# EUROPEAN PATENT SPECIFICATION

(11) **EP 1 381 058 B1**
(45) Date of publication and mention of the grant of the patent: **22.11.2006**
(21) Application number: 02711401.6
(22) Date of filing: 08.02.2002
(51) Int. Cl.: H01B 5/14, H01B 13/00, H01B 7/00, H01B 7/18, C08J 7/18, G02F 1/00

(54) **CONDUCTIVE ORGANIC THIN FILM AND PRODUCTION METHOD THEREFOR, ELECTRODE AND ELECTRIC CABLE USING IT**
LEITFÄHIGER ORGANISCHER DÜNNFILM UND HERSTELLUNGSVERFAHREN DAFÜR, ELEKTRODE UND ELEKTRISCHES KABEL DAMIT
FILM MINCE ORGANIQUE CONDUCTEUR ET SON PROCEDE DE PRODUCTION, ELECTRODE ET CABLE ELECTRIQUE UTILISANT CE FILM

(30) Priority: 17.04.2001 JP 2001118666; 22.11.2001 JP 2001358340
(43) Date of publication of application: 14.01.2004
(73) Proprietor: MATSUSHITA ELECTRIC INDUSTRIAL CO., LTD., Kadoma-shi, Osaka 571-8501 (JP)
(72) Inventor: OGAWA, Kazufumi, Nara-shi, Nara 630-8101 (JP); MINO, Norihisa, Nara-shi, Nara 631-0033 (JP); YAMAMOTO, Shinichi, Hirakata-shi, Osaka 573-1113 (JP)
(74) Representative: Koepe, Gerd L.
(86) International application number: PCT/JP2002/001067
(87) International publication number: WO 2002/086913

(56) References cited:
- EP-A1- 0 552 637
- EP-A1- 0 962 460
- EP-A2- 0 339 677
- EP-A2- 0 383 584
- JP-A- 3 229 710
- JP-A- 5 081 921
- JP-A- 5 175 485
- JP-A- 5 274 919
- JP-A- 9 162 440
- JP-A- 60 146 406
- JP-A- 2000 268 634
- JP-Y1- 34 019 965
- BERLIN, ZOTTI: "Self-assembly of mono- and multilayers of polyconjugated conducting polymers" MACROMOLECULAR RAPID COMMUNICATIONS, vol. 21, 2000, pages 301-318, XP002317595
- MICHALITSCH, NOGUES, NAJARI, ELKASSMI, YASSAR, LANG, GARNIER: "Functionalized Oligothiophenes for molecular self-assembly" SYNTHETIC METALS, vol. 101, 1999, pages 5-6, XP002317596
- COLLARD, STOAKES: "Lamellar Conjugated Polymers by electrochemical polymerization of heteroarene containing surfactants: potassium 3-(3-Alkylpyrrol-1-yl)propanesulfonates" CHEMISTRY OF MATERIALS, vol. 6, 1994, pages 850-857, XP002317597
- LO, RITCHIE, ZHOU, ZHAO, MCDEVITT: "Polypyrrole growth on YBa2C3O7 modified with a self-assembled monolayer of N-(3-aminopropyl)pyrrole: Hardwiring the "electroactive hot spots" on a Superconductor electrode" JOURNAL OF THE AMERICAN CHEMICAL SOCIETY, vol. 118, 1996, pages 11295-11296, XP002317598

## Description

### TECHNICAL FIELD

The present invention relates to conductive organic thin films using an organic material, methods for manufacturing the same, as well as electrodes and electric cables using the same. The present invention further relates to monomolecular films and monomolecular built-up films having conductivity.

### BACKGROUND ART

Various organic conductive films have been proposed in the past. The applicant of this application already has proposed conductive films including conductive conjugated groups, such as polyacetylene, polydiacetylene, polyacene, polyphenylene, polythienylene, polypyrrole, or polyaniline (JP H2(1990)-27766A, USP 5,008127, EP-A-0385656, EP-A-0339677, EP-A-0552637, USP 5,270,417, JP H5(1993)-87559A, JP H6(1994)-242352A).

Moreover, inorganic semiconductor materials, for which crystalline silicon is a typical example, conventionally have been used in electronic devices. Electronic devices on an organic base (referred to below as organic electronic devices) have been disclosed for example in Japanese Patents No. 2034197 and 2507153. In the organic electronic devices described in these publications, the current flowing between terminals is switched in response to an applied electric field.

In the above-mentioned conventional organic conductive films, there was the problem that their conductivity is lower than that of metal. Furthermore, in the inorganic crystals used conventionally, crystal defects are becoming a problem as miniaturization proceeds, and there was the problem that device performance varies strongly with the crystal properties. Furthermore, there was the problem that flexibility is poor.

The document Berlin, Zotti: "Self-assembly of mono- and multilayers of polyconjugated conducting polymers" in Macromolecular Rapid Communications, vol. 21, 2000, pages 301 - 318, XP002317595 relates to organised mono- and multilayers of polyconjugated polymers or oligomers.

The document Michalitsch, Nogues, Najari, Elkassmi, Yassar, Lang, Garnier: "Functionalized oligothiophenes for molecular self-assembly" in Synthetic Metals, vol. 101, 1999, pages 5 - 6, XP002317596 describes oligothiophenes carrying an alkylthiol group on one of the internal β-positions for forming self-assembled monolayers.

EP-A 0 383 584 relates to organic electro-conductive thin films exhibiting electroconductivity. The organic thin film is composed mainly of organic compound molecules having a straight-chain hydrocarbon group. Acetylene groups are formed on long-chain hydrocarbon groups in the organic compound molecules, as a functional group, and polyacetylene is formed through polymerisation between the mutual organic compound molecules.

The monomolecular film disclosed in JP-A 3229710 is formed by a straight-chain compound having an unsaturated group (e.g. an acetylene group), a chlorosilane group (-Si-Cl) and an oxygen atom between hydrocarbon chains.

EP-A 0 552 637 discloses a method of manufacturing a polyacetylene type superlong conjugate polymer. The polymer is made by chemically adsorbing a chemical adsorption substance containing an acetylene group and a chlorosilyl group, for example ω-nonadecylinoic trichlorosilane, to a substrate surface, and polymerising the acetylene group whereby polyacetylene is produced.

EP-A 0 339 677 relates to a process for producing polyacetylene or polyacene type super long conjugated polymers. A substance having an acetylenic group and chlorosilanyl group, for example ω-nonadecylinoic trichlorosilane, is adsorbed onto the surface of a substrate and a monomolecular film of said substance can be prepared on the substrate in the state where the molecules are well aligned and polymerised.

The document Collard, Stoakes: "Lamellar conjugated polymers by electrochemical polymerization of heteroarene-containing surfactants: potassium-3-(3-alkylpyrrol-1-yl)propanesulfonates" in Chemistry of Materials, vol. 6, 1994, pages 850 - 857, XP002317597 discloses a series of self-assembling monomers, potassium-3-(3-alkylpyrrol-1-yl)propanesulfonates, which are electrooxidatively polymerized from micellar solution to afford lamellar phases of the substituted polypyrrole.

### DISCLOSURE OF THE INVENTION

In view of the foregoing, it is a first object of the present invention to present a conductive organic thin film whose conductivity is higher than that of conventional organic thin films, as well as a method for manufacturing the same.

It is a second object of the present invention to present organic electronic devices with excellent flexibility by forming electrodes made of a conductive organic thin film whose crystallinity is not affected even when the device density is increased and microprocessing at 0.1 µm or less is performed.

To attain these objects, in accordance with the present invention, a conductive organic thin film is made of organic molecules including a terminal bond group that is covalently bonded to a surface of a substrate material or a surface of a primer layer formed on the substrate material, a conjugated bond group, and an alkyl group between the terminal bond group and the conjugated bond group, wherein the organic molecules are oriented, and the conjugated bond group is polymerized with the conjugated bond groups of other molecules, thus forming a conductive network by electrolytic polymerization carried out by contacting electrodes directly with the film. The conductive network is linked and has a conductive anisotropy in a plane of the conductive organic thin film, and the conductive organic thin film is a monomolecular film or a monomolecular built-up film. The molecular units forming the conductive network can be expressed by the following Chemical Formula (A) or (B) 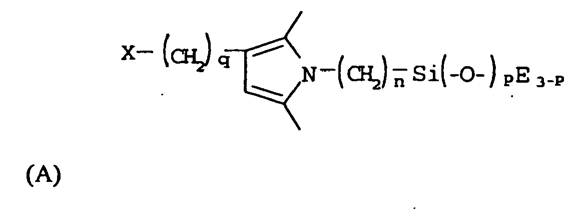 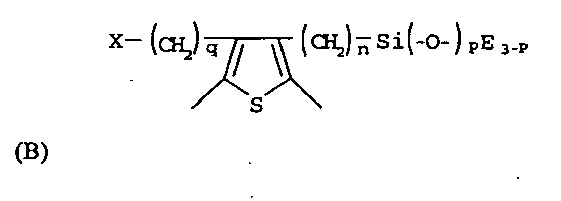 wherein X denotes hydrogen, an ester group or an organic group including an unsaturated group, q denotes an integer of 0 to 10, E denotes hydrogen or an alkyl group with a carbon number of 1 to 3, n denotes an integer of at least 2 and at most 25, and p denotes an integer of 1,2 or 3.

A method of manufacturing a conductive organic thin film in accordance with the present invention includes bringing a chemisorptive compound comprising a terminal functional group that can covalently bond to a surface of a substrate material or a surface of a primer layer formed on the substrate material, a conjugated bondable functional group, and an alkyl group between the terminal functional group and the conjugated bondable functional group in contact with the surface of the substrate material or the surface of the primer layer formed on the substrate material, said surface having active hydrogen or being furnished with active hydrogen, thus forming covalent bonds by an elimination reaction, orienting the organic molecules constituting the organic thin film in a predetermined direction or orienting them during the polymerization step, and forming a conductive network by bonding the conjugated bondable groups to one another by conjugated bonding in the polymerization step by electrolytic polymerization carried out by contacting electrodes directly with the film. The conductive network is linked and has a conductive anisotropy in a plane of the conductive organic thin film, and the conductive organic thin film is a monomolecular film or a monomolecular built-up film. The organic molecules can be expressed by the following Chemical Formula (C) or (D) 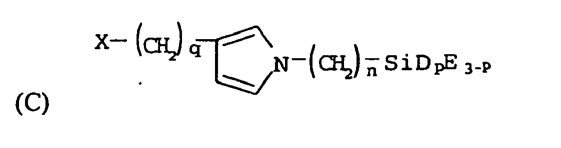 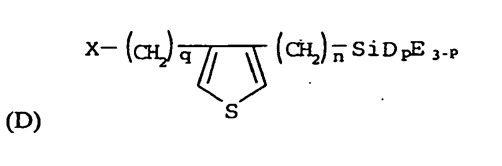 wherein X denotes hydrogen, an ester group or an organic group including an unsaturated group, q denotes an integer of 0 to 10, D denotes a halogen atom, an isocyanate group or an alkoxyl group with a carbon number of 1 to 3, E denotes hydrogen or an alkyl group with a carbon number of 1 to 3, n denotes an integer of at least 2 and at most 25, and p denotes an integer of 1, 2 or 3.

An electrode in accordance with the present invention is formed with a conductive organic thin film that is transparent at an optical wavelength in a visible optical region, wherein the conductive organic thin film is made of organic molecules comprising a terminal bond group that is covalently bonded to a surface of a substrate material or a surface of a primer layer formed on the substrate material, a conjugated bond group, and an alkyl group between the terminal bond group and the conjugated bond group, and wherein the organic molecules are oriented, and the conjugated bond group is polymerized with the conjugated bond groups of other molecules, thus forming a conductive network product by electrolytic polymerization carried out by contacting electrodes directly with the film. The conductive network is linked and has a conductive anisotropy in a plane of the conductive organic thin film, and the conductive organic thin film is a monomolecular film or a monomolecular built-up film. The molecular units forming the conductive network can be expressed by the following Chemical Formula (A) or (B) 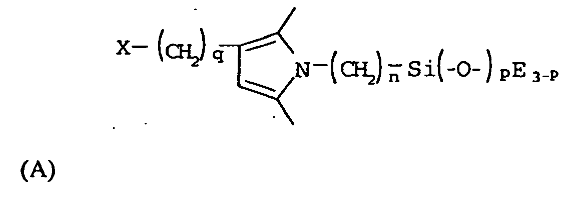 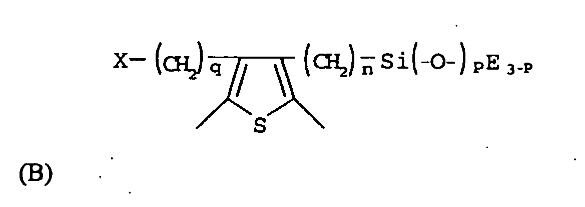 wherein X denotes hydrogen, an ester group or an organic group including an unsaturated group, q denotes an integer of 0 to 10, E denotes hydrogen or an alkyl group with a carbon number of 1 to 3, n denotes an integer of at least 2 and at most 25, and p denotes an integer of 1, 2 or 3.

An electric cable in accordance with the present invention includes a core and a conductive organic thin film formed in a longitudinal direction on a surface of the core, wherein the conductive organic thin film is made of organic molecules comprising a terminal bond group that is covalently bonded to a surface of a substrate material or a surface of a primer layer formed on the substrate material, a conjugated bond group, and an alkyl group between the terminal bond group and the conjugated bond group, and wherein the organic molecules are oriented, and the conjugated bond group is polymerized with the conjugated bond groups of other molecules, thus forming a conductive network product by electrolytic polymerization carried out by contacting electrodes directly with the film. The conductive network is linked and has a conductive anisotropy in a plane of the conductive organic thin film, and the conductive organic thin film is a monomolecular film or a monomolecular built-up film. The molecular units forming the conductive network can be expressed by the following Chemical Formula (A) or (B) 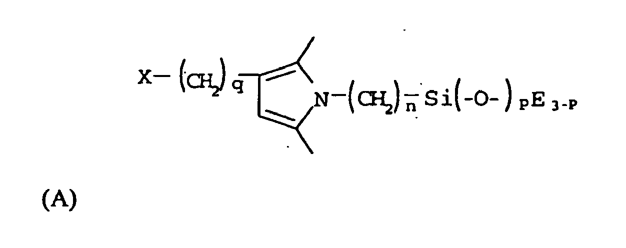 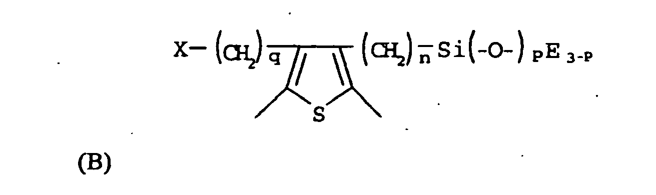 wherein X denotes hydrogen, an ester group or an organic group including an unsaturated group, q denotes an integer of 0 to 10, E denotes hydrogen or an alkyl group with a carbon number of 1 to 3, n denotes an integer of at least 2 and at most 25, and p denotes an integer of 1, 2 or 3.

### BRIEF DESCRIPTION OF THE DRAWINGS

Fig. 1A is a cross-sectional view of a monomolecular film provided with a conductive network across the entire region in accordance with Embodiment 1 of the present invention. Fig. 1B is a cross-sectional view of a monomolecular film provided with a conductive network at a plurality of regions. Fig. 1C is a cross-sectional view of a monomolecular film that is made of organic molecules having conjugated polymerizable functional groups inside, in which the conductive network is formed in a plurality of regions.
Fig. 2 is a schematic plan view illustrating the direction of the conductive network in Embodiment 2 of the present invention.

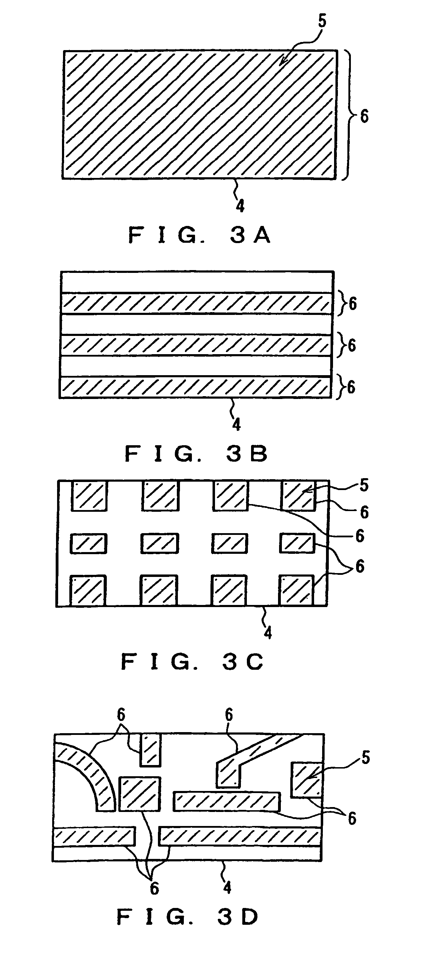

Fig. 3A is a plan view of a monomolecular layer, in which a conductive network linked in one direction is formed across the entire region in Embodiment 1 of the present invention. Fig. 3B is a plan view of a monomolecular layer having parallel conductive regions, each conductive region provided with a conductive network that is linked in one direction. Fig. 3C is a plan view of a monomolecular layer having conductive regions arranged in a matrix, each conductive region provided with a conductive network that is linked in one direction. Fig. 3D is a plan view of a monomolecular layer having conductive regions arranged in desired
patterns, wherein the directions of the conductive networks formed in each of the conductive regions are the same, and the shapes of the conductive regions are not the same.

Fig. 4A is a cross-sectional view schematically showing an example of the structure of a monomolecular film formed on a substrate material according to Embodiment 1 of the present invention. Fig. 4B is a cross-sectional view of a monomolecular film formed on the substrate material and provided with a protective film at its surface.

Fig. 5A is a schematic perspective view illustrating a rubbing orientation for tilting (orienting) the molecules constituting the organic thin film in Embodiment 1 of the present invention. Fig. 5B is a perspective view of optical orientation. Fig. 5C is a perspective view of orientation by letting a solution run off.

Fig. 6A is a perspective view schematically showing a configuration example, in which the conductive regions are formed at selective locations on the substrate material in Embodiment 1 of the present invention. Fig. 6B is a perspective view, in which a plurality of monomolecular films provided with conductive regions across the entire region have been formed on the substrate material.

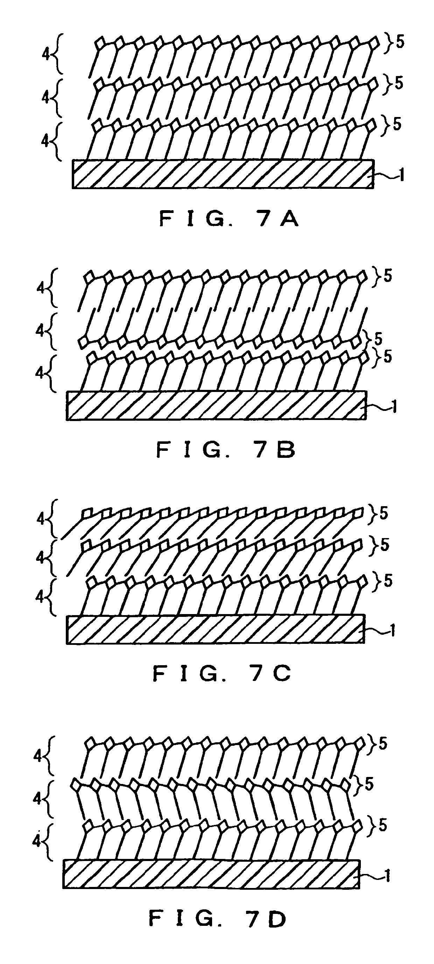

Figs. 7A to 7D are cross-sectional views schematically showing examples of the layering structure of a monomolecular built-up film formed on the substrate material in Embodiment 2 of the present invention. Fig. 7A shows an X-type monomolecular built-up film in which the orientation direction of all monomolecular layers is the same. Fig. 7B shows a Y-type monomolecular built-up film in which the orientation direction of all monomolecular layers is the same. Fig. 7C shows an X-type monomolecular built-up film in which the orientation direction is different for each monomolecular layer. Fig. 7D shows an X-type monomolecular built-up film in which all monomolecular layers are oriented in one of two orientation directions.

Fig. 8A is a cross-sectional view of an electric cable formed on an outer surface of a core in accordance with Embodiment 12 of the present invention. Fig. 8B is a perspective view of an aggregate conductor-type electric cable according to Embodiment 3 of the present invention. Fig. 8C is a perspective view of an aggregate conductor-type flat cable according to Embodiment 3 of the present invention.

Figs. 9A and 9B are cross-sectional views schematically showing examples of the structure of capacitors using a conductive region formed in a monomolecular film according to Embodiment 4 of the present invention as electrodes. Fig. 9A shows a structure in which a dielectric is sandwiched by two substrate materials provided with monomolecular films having a conductive region, wherein the monomolecular films are arranged on the inner side. Fig. 9B shows a structure in which monomolecular films having a conductive region are formed on two parallel surfaces of a dielectric.

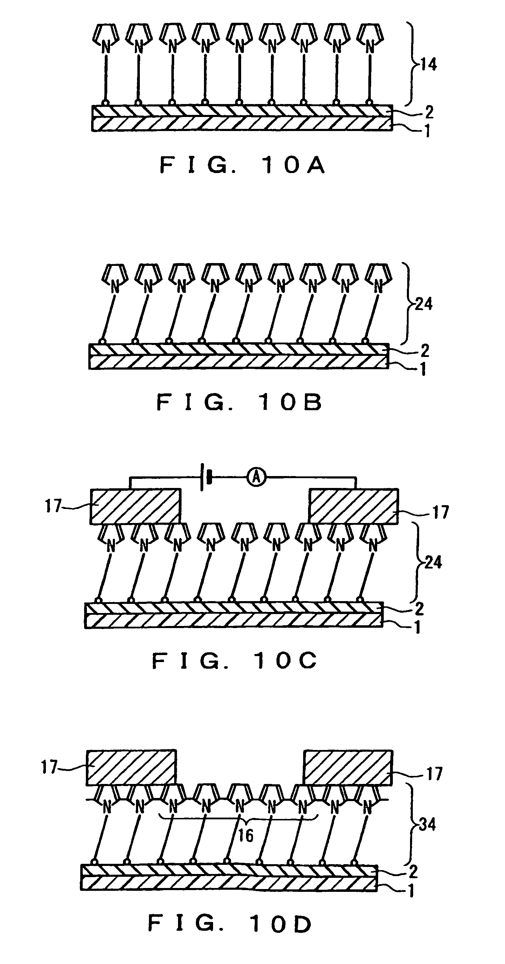

Figs. 10A to 10D are cross-sectional views illustrating the manufacturing steps for manufacturing a monomolecular film having a conductive region according to Embodiment 1 and Embodiment 6 of the present invention. Fig. 10A shows a monomolecular film that has been formed on a substrate material by a monomolecular layer formation step. Fig. 10B shows a monomolecular film that has been oriented by a tilt processing (orientation processing) step. Fig. 10C shows a monomolecular film immediately after starting a conductive region formation step of applying a voltage to a pair of electrodes formed on its surface in a polymerization electrode formation step. Fig. 10D shows a monomolecular film that has been provided with a conductive network by a conductive region formation step.

Figs. 11A to 11F are diagrams of manufacturing steps of an organic conductive film according to Working Example 2 of the present invention.

Figs. 12A and 12B are cross-sectional diagrams illustrating processes for orienting the molecules in a molecule layer according to Working Example 2 of the present invention.

Fig. 13 is a cross-sectional diagram illustrating an organic electronic device according to Working Example 3 of the present invention.

Fig. 14 is a cross-sectional diagram illustrating a liquid crystal display device according to Working Example 4 of the present invention.

Fig. 15 is a cross-sectional diagram illustrating an electroluminescence (EL) display device according to Working Example 5 of the present invention.

Fig. 16 is a diagram illustrating a method for evaluating the orientation of conductive molecules according to Working Example 14 of the present invention.

Fig. 17 is an NMR chart of the product obtained by Working Example 1 of the present invention.

Fig. 18 is an IR chart of the product obtained by Working Example 1 of the present invention.
1: substrate material (substrate), 2: substrate material insulating film, 3: protective film, 4: monomolecular film (monomolecular layer), 5: conjugated system (chain of conjugated bonds), 6: conductive region, 7: metal contact point (wiring), 8: dielectric, 9: conjugated polymerizable functional group, 11: insulating substrate material, 13: insulating protective film, 14: monomolecular film made of organic molecules having a pyrrole group, 16: conductive region having polypyrrole-type conductive network, 17: platinum electrode for electrolytic polymerization, 24: monomolecular film with oriented organic molecules having a pyrrole group, 34: monomolecular film having polypyrrole-type conductive network, 41: rubbing roll, 42: rubbing cloth, 43: polarizer, 44: organic washing solution

### BEST MODE FOR CARRYING OUT THE INVENTION

In the present invention, the fact that the organic thin film has conductivity is due to the polymerization with conjugated bonds of the molecules constituting a cluster of organic molecules. Here, a conductive network is an aggregation of organic molecules that are bonded by conjugated bonds contributing to conductivity, and is formed by a polymer having a chain of conjugated bonds (conjugated system). Moreover, the conductive network is formed in a direction connecting the electrodes. Strictly speaking, such a polymer chain of conjugated bonds is not linked in one direction, but polymer chains of several directions may be formed that taken as a whole connect the electrodes.

In the present invention, the conductivity (p) of the conductive organic film is at least 1 S/cm, preferably at least 1 × 10² S/cm, and more preferably at least 1 × 10³ S/cm. These values are all for room temperature (25°) and without doping.

It is preferable that the polymerized conjugated bond group is at least one conjugated bond group selected from polypyrrole and polythienylene. In particular when the conjugated bond group is polypyrrole or polythienylene and the thin film has been polymerized by electrolytic oxidation, then its conductivity is high.

It is preferable that the terminal bond group is at least one bond selected from siloxane (-SiO-) and SiN- bonds.

The terminal bond group is formed by at least one elimination reaction selected from dehydrochlorination reaction, dealcoholization reaction and deisocyanation reaction. For example, if the functional group at the molecule end is -SiCl₃, -Si(OR)₃ (wherein R is an alkyl group with a carbon number of 1 to 3), or -Si(NCO)₃, then there is active hydrogen present in the -OH, -CHO, -COOH, -NH₂ and >NH groups formed at the substrate material surface or the surface of a primer layer formed on the substrate material, so that a dehydrochlorination reaction, a dealcoholization reaction or a deisocyanation reaction occurs, and the chemisorptive molecules are covalently bonded to the substrate material surface of the surface of a primer layer formed on the substrate material.

Molecular films formed by this method are known in the art as "chemisorptive films" or "self-assembling films," but in the present invention, they are referred to as "chemisorptive films." Furthermore, their formation method is referred to as "chemisorption."

In accordance with the present invention, it is preferable that the orientation of the molecules is achieved by at least one selected from an orientation process by rubbing, a process of letting a reaction solution run off the tilted substrate surface after covalently bonding the molecules to the substrate surface in an elimination reaction, a process of irradiating polarized light, and orientation by fluctuations of the molecules during the polymerization step.

It is preferable that the conductive region of the organic thin film is transparent to light of a wavelength in the visible region.

According to the invention the molecular units forming the conductive network can be expressed by the following Chemical Formula (A) or (B): 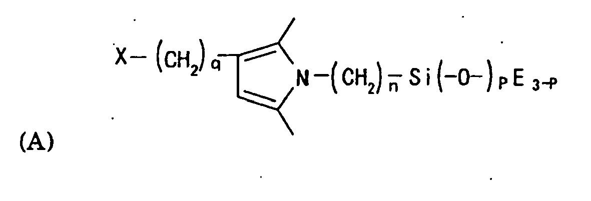 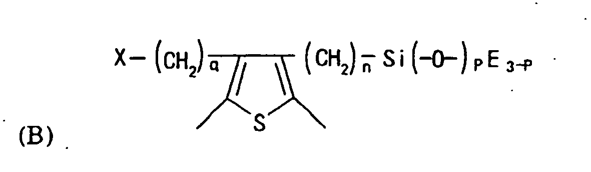 wherein X denotes hydrogen, an ester group or an organic group including an unsaturated group, q denotes an integer of 0 to 10, E denotes hydrogen or an alkyl group with a carbon number of 1 to 3, n denotes an integer of at least 2 and at most 25, preferably at least 10 and at most 20, and p denotes an integer of 1, 2 or 3.

The compound forming the conductive network is a pyrrolyl compound or a thienyl compound expressed by the following Chemical Formula (C) or (D): 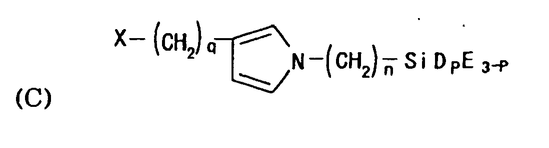 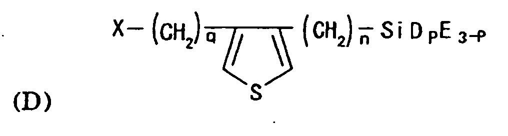 wherein X denotes hydrogen, an ester group or an organic group including an unsaturated group, q denotes an integer of 0 to 10, D denotes a halogen atom, an isocyanate group or an alkoxyl group with a carbon number of 1 to 3, E denotes hydrogen or an alkyl group with a carbon number of 1 to 3, n denotes an integer of at least 2 and at most 25, and p denotes and integer of 1, 2 or 3.

It is preferable that the conjugated bondable group is at least one group selected from pyrrole and thienylene.

It is preferable that the organic molecules are formed into a monomolecular layer.

It is also possible to layer monomolecular layers into a monomolecular built-up film by repeating the monomolecular layer formation step a plurality of times.

If X in Chemical Formula A or B includes an ester group, then it is possible to introduce a carboxyl group (-COOH) by hydrolysis. If X includes an unsaturated group, for example a vinyl group, then it is possible to introduce a hydroxyl group (-OH) by irradiating an energy beam such as an electron beam or X-rays in a water-containing atmosphere. Furthermore, if X includes an unsaturated group, for example a vinyl group, then it is possible to introduce -COOH by immersion in an aqueous solution of potassium permanganate, for example. Thus, active hydrogen can be introduced, so that the monomolecular films can be bonded together in a stacked fashion.

It is also possible to form a conductive monomolecular built-up film by repeating the monomolecular layer formation step and the tilt processing (orientation) step in alternation, and then collectively forming a conductive network in the various monomolecular layers of the monomolecular built-up film by the conductive network formation step.

It is further possible to form a conductive monomolecular built-up film by repeating a series of steps including the monomolecular layer formation step, the tilt processing step and the conductive network formation step.

The polymerization is carried out by electrolytic polymerization through electrolytic oxidation. It is also possible to perform at least one pre-polymerization selected from catalytic polymerization and polymerization through energy beam irradiation, before forming the conductive network by electrolytic oxidation.

It is preferable that the energy beam is at least one selected from ultraviolet light, infrared light, X-rays and electron beams.

It is also possible that the energy beam is at least one selected from polarized ultraviolet light, polarized infrared light and polarized X-rays, and the tilt orientation processing and the conductive network formation are carried out simultaneously.

When the organic molecules include functional groups having polarity, then the sensitivity with respect to the applied electric field becomes high, and the speed of response becomes fast. Consequently, the conductivity of the organic thin film can be changed quickly. It seems that the change of the conductivity of the organic thin film when applying an electric field occurs because the functional groups with polarity respond to the electric field, and the effect of this response affects the structure of the conductive network.

Furthermore, when a dopant substance with carrier mobility is incorporated in the conductive network by doping, then the conductivity can be increased even more. As dopant substances, it is possible to use iodine, BF⁻ ions, alkali metals such as Na or K, alkali earth metals such as Ca or any other suitable dopant substance. It is also possible to include dopant substances by contamination that are unavoidably admixed in trace amounts included in the solution of the organic film formation step or from the glass container.

Since the organic molecules constituting the conductive monomolecular layer are in a relatively well oriented state, the chains of conjugated bonds of the conductive network are within a certain plane. Consequently, the conductive network formed in the monomolecular layer is linearly linked in a predetermined direction. Due to the linearity of this network, it has a high conductive anisotropy. Furthermore, the linearity of the conductive network means that the chains of conjugated bonds (conjugated systems) constituting the conductive network are arranged substantially parallel within the same plane in the monomolecular layer. Consequently, the conductive monomolecular layer has a high and uniform conductance. Furthermore, due to the linearity of the conductive network, it has conjugated bond chains with a high polymerization degree in the monomolecular layer.

According to another configuration, a conductive monomolecular film and a conductive monomolecular built-up film that are thin but have extremely favorable conductivity characteristics are provided.

In the case of a conductive monomolecular built-up film, the conductive networks are formed in the conductive monomolecular layers, so that the conductance of the conductive network of the monomolecular built-up film depends on the number of layered monomolecular films. Consequently, by changing the layered number of conductive monomolecular layers, a conductive organic thin film can be provided that has a desired conductance. For example, with a conductive stacked film in which the same conductive monomolecular layers are layered, the conductance of the conductive network included therein is substantially proportional.

As long as the directions of the conductive networks formed in all monomolecular layers in the conductive monomolecular built-up film are the same, the tilt angle of the orientation of the organic molecules can be different for each monomolecular layer. Furthermore, it is also possible that not all monomolecular layers are made of the same organic molecules. Furthermore, a conductive monomolecular built-up film made of different kinds of organic molecules for each conductive monomolecular layer is also possible.

Furthermore, in the case of a conductive monomolecular built-up film, the conductive monomolecular layer nearest to the substrate material is bonded to the substrate material by chemical bonds, so that the durability characteristics, such as peeling, are excellent.

The tilt direction of the organic molecules in the tilt processing step means the direction of the segment obtained by projecting the long axis of the organic molecules onto the surface of the substrate material. Consequently, the tilt angle with respect to the substrate material does not have to be one uniform angle.

The cluster of organic molecules constituting the monomolecular layer can be tilted in a predetermined direction with high precision in the tilt processing step. Generally, the molecules constituting the monomolecular layer can be oriented. Since they can be oriented with high precision, a conductive network with directionality can be formed easily in the conductive network formation step.

Moreover, when conjugated bonding is achieved between the organic molecules that have been oriented in the monomolecular layer, then a conductive network can be formed that has a high polymerization degree and that is linearly linked. Moreover, due to the linearity of the conductive network, it is possible to form a uniform conductive monomolecular layer.

In another configuration, polarized light of a wavelength in the visible region is used for the above-mentioned polarized light. With this configuration, peeling of the organic molecules constituting the organic thin film and destruction of the organic thin film through destruction of the organic molecules themselves can be prevented or suppressed.

In another configuration, when an organic thin film is formed on the surface of a substrate material that has been subjected to a rubbing process, then the organic molecules constituting this organic thin film become tilted in a predetermined direction. In general, the rubbing direction in the rubbing process and the tilt direction of the formed organic molecules will be the same.

For the rubbing cloth used in the rubbing process, it is possible to use a cloth made of nylon or rayon. Using a rubbing cloth made of nylon or rayon is consistent with the object of improving the precision of the orientation.

In the conductive network formation step, the conductive network may be formed by conjugated bonds by polymerizing the molecules constituting the organic thin film or by polymerization followed by crosslinking. With this configuration, a conductive network can be formed, in which the polymerizable groups of the organic molecules are linked by conjugated bonds and electric conductance becomes possible. The polymerization, is carried out through electrolytic oxidation. If the conductive network is completed by polymerization through electrolytic oxidation in the final step, a high conductivity can be attained.

Moreover, if the molecules forming the organic thin film have a plurality of polymerizable groups that can be bonded together by conjugated bonds, then, by further subjecting the polymer molecules formed in the polymerization of some polymerizable groups to a crosslinking reaction and bonding them to other polymerizable groups by conjugated bonds, it is possible to form a conductive network having a structure that is different from the structure after polymerization. Herein, the other polymerizable groups that are in the side chains of the polymer molecules formed by polymerization are crosslinked.

If the crosslinking step is performed a plurality of times, then it is possible to combine crosslinking steps with different operative effects, but it is also possible to combine steps with the same operative effect but different reaction conditions.

In the conductive network formation step, electrolytic polymerization is applied as the polymerization method, and the conductive network may be formed in an organic thin film made of a cluster of organic molecules having, as the polymerizable group, a pyrrole group or a thienylene group.

For example, a conductive network including polypyrrole-type conjugated systems may be formed using organic molecules including a pyrrole group, or a conductive network including polythienylene-type conjugated systems may be formed using organic molecules including a thienylene group.

The substrate may be an electrically insulating substrate, for example made of glass or a resin film, or a substrate with an insulating film, that is, a substrate having an insulating film formed on a suitable substrate surface. If the substrate is made of glass or a polyimide resin, then it has active hydrogen at its surface, so that it can be used in unaltered form. If it is a substrate with little active hydrogen, then it may be furnished with active hydrogen by processing it with SiCl₄, HSiCl₃, SiCl₃O-(SiCl₂-O)ₙ-SiCl₃ (wherein n is an integer of at least 0 and at most 6), Si(OCH₃)₄, HSi(OCH₃)₃, Si(OCH₃)₃O-(Si(OCH₃)₂-O)ₙ-Si(OCH₃)₃ (wherein n is an integer of at least 0 and at most 6), forming a silica film, or activating the substrate surface by corona discharge, plasma irradiation or the like.

If the substrate is an electrically insulating substrate, then there is little leakage current, and an organic electronic device with superior operation stability can be provided.

The organic conductive film of the present invention has high conductivity and high transparency. Conceivable applications making use of these characteristics are conductors, motors, generators, capacitors, transparent electrodes (replacing ITO), semiconductor device wiring / CPU wiring (no heat is generated due to the low resistance), electromagnetic shields, CRT glass surface filters (with prevention of static electricity), and so forth.

### Embodiment 1

Embodiment 1 explains a manufacturing method of an organic thin film and its structure, taking a monomolecular film as an example.

First the manufacturing method is explained. A monomolecular layer formation step (organic thin film formation step) is carried out, in which organic molecules including conjugated polymerizable functional groups are brought in contact with a substrate material, and a monomolecular film is formed on the substrate material. Next, a monomolecular film having a conductive region is formed by carrying out a conductive region formation step in which at least a portion of the monomolecular film is provided with a conductive region having a conductive network in which the molecules constituting the monomolecular film are linked to one another in a predetermined direction by conjugated bonds.

In order to form a conductive network with a better directionality than the conductive network formed by this manufacturing method, it is preferable to subject a monomolecular film, in which the organic molecules constituting the film are oriented (tilted) in a predetermined direction, to the conductive region formation step. Also, when an oriented monomolecular film is subjected to the conductive region formation step, a conductive region with high polymerization degree and conductance can be formed.

Here, in monomolecular films and monomolecular layers, tilting in a predetermined direction is equivalent to orienting the organic molecules constituting the monomolecular film, so that with respect to monomolecular films and monomolecular layers, it is also referred to as "orientation" in the following.

As a method for forming such an oriented monomolecular film, it is possible to apply for example a method of rubbing the substrate material surface before the monomolecular layer formation step (preprocessing step) and forming the monomolecular film on the rubbed substrate material surface, or a method of forming an oriented monomolecular film by performing first a monomolecular layer formation step and then subjecting the monomolecular film to an orientation process (tilt processing step). Furthermore, with a manufacturing method including a preprocessing step and a tilt processing step, it is possible to form a conductive network with superior linearity.

If the manufacturing method includes a washing step subsequent to this monomolecular layer formation step, then it is possible to form a monomolecular film without stains on its surface. If the manufacturing method includes a doping step of doping with a dopant with carrier mobility, then the conductance of the conductive region can be increased conveniently. Also, if the manufacturing method includes a step of forming an insulating protective film on the monomolecular film after the conductive region formation step, then it is possible to manufacture a monomolecular film with a protective film that has superior durability characteristics, such as peeling resistance. The following is an explanation of these steps.

In the monomolecular film formation step, it is possible to form the monomolecular film by immersing the substrate material in an organic solution including film material molecules, but it is also possible to form the monomolecular film by applying the organic solution onto the substrate material. Furthermore, the monomolecular film also can be formed by exposing the substrate material to a gas including the film material molecules.

When organic molecules having at their ends functional groups that are chemically adsorbed to the substrate material, such as silane-based surface active agents, are used as the film material molecules, then a monomolecular film can be formed that is bonded and fixed to the substrate material and has superior durability characteristics, such as peeling resistance. When second and further film layers are formed, then it is possible to apply chemisorption or the Langmuir-Blodgett method.

Moreover, the monomolecular layer formation step may be a step of forming the monomolecular film on the entire surface or a portion of the substrate material, and may also be a step of forming the monomolecular film in a predetermined pattern on the substrate material. For example, it is possible to form a coating (resist pattern) at the positions outside the pattern in which the monomolecular film is formed on the substrate material surface, form the monomolecular film by bringing the substrate material provided with the coating in contact with film material molecules, and then form the monomolecular film with a predetermined pattern by removing the coating.

Next, in the washing step, non-adsorbed organic molecules can be washed off after the monomolecular layer formation step by immersing the substrate material on which the monomolecular film has been formed in an organic solvent for washing. It is preferable that a non-aqueous organic solvent is used as the organic solvent for washing.

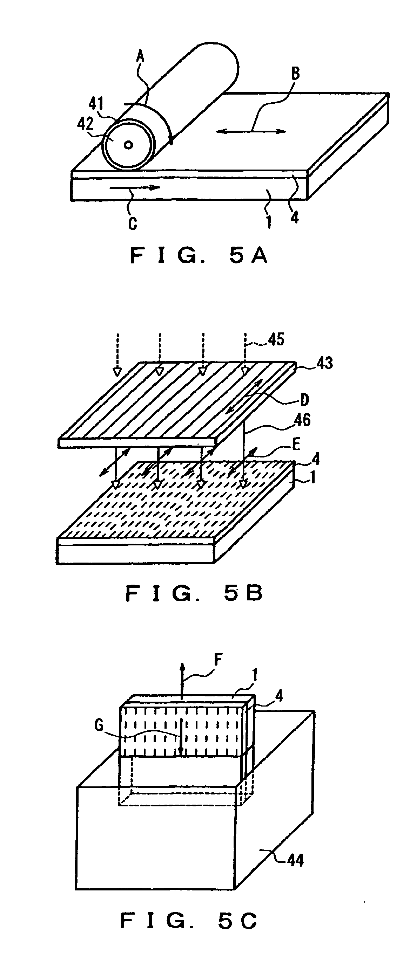

Next, in the orientation processing step, the surface of the substrate material can be rubbed in one desired direction, but it is also possible to perform a step of rubbing predetermined regions in different rubbing directions. The rubbing method is explained in the following tilt processing step. The rubbing device used in the orientation processing step and the rubbing device used in the tilt processing step are the same device, and the difference is whether the monomolecular film has been formed on the substrate material or not (Fig. 5A).

The following is an explanation of an example of the preprocessing step for the case that the rubbing direction is different at predetermined locations. A coating (resist pattern) with a predetermined first pattern is formed on the substrate material surface, the substrate material surface where the coating has not been formed is rubbed in a predetermined first rubbing direction, and after the rubbing process, the coating is removed. After that, a coating (resist pattern) with a second pattern that is different from the first pattern is formed on the substrate material surface, the substrate material surface where the coating has not been formed is rubbed in a predetermined second rubbing direction, and after the rubbing process, the coating is removed. Thus, locations that have been rubbed in a first rubbing direction and locations that have been rubbed in a second rubbing direction can be formed. Moreover, by repeating this with different rubbing directions, a complex rubbing pattern can be formed.

Next, in the orientation processing step (tilt processing step), the organic molecules constituting the monomolecular film can be oriented in a predetermined direction by applying rubbing orientation, optical orientation or orientation by letting a solution run off the surface. Figs. 5A to 5C are schematic perspective views illustrating the orientation methods for tilting (orienting) the molecules constituting the organic thin film. Fig. 5A shows rubbing orientation, Fig. 5B shows optical orientation and Fig. 5C shows orientation by letting a solution run off.

As shown in Fig. 5A, rubbing orientation is a method in which a rubbing roll 42, around which a rubbing cloth 41 contacting the monomolecular film 4 has been wound, is rotated in a rotation direction A while transporting the substrate material 1 on which the monomolecular film 4 has been formed in a predetermined direction (substrate transport direction) C, so that the organic molecules constituting the monomolecular film 4 are oriented in the rubbing direction B by rubbing the surface of the monomolecular film 4 with the rubbing cloth 41. Thus, a monomolecular film 4 that has been oriented in the rubbing direction B can be formed on the substrate material 1.

As shown in Fig. 5B, optical orientation is a method in which ultraviolet or visible light beams 45 are irradiated onto a polarizer 43 having a transmission axis direction D, and the organic molecules constituting the monomolecular film 4 are oriented by polarized light 46 in a polarization direction E. For the polarized light, directly polarized light is preferable. Thus, a monomolecular film 4 that has been oriented in the polarization direction can be formed on the substrate material 1.

Furthermore, as shown in Fig. 5C, orientation by letting a solution run off is a method in which the substrate material 1 is lifted in a lifting direction F while holding a predetermined tilting angle with respect to the liquid surface of an organic solvent 44 for washing, and the organic molecules constituting the monomolecular film 4 are oriented in a direction G in which the solution runs off. Thus, an oriented monomolecular film 4 can be formed on the substrate material 1.

Furthermore, even though it is not shown in the drawings, it is also possible to perform orientation by fluctuation of molecules in the solution during polymerization through electrolytic oxidation.

It is possible to apply any one method of orientation by letting a solution run off, rubbing orientation, optical orientation, an orientation by fluctuation of molecules in the solution during polymerization, but it is also possible to combine a plurality of orientation methods and apply them one after another. When combining different orientation methods to form an oriented monomolecular film with the precise orientation, it is preferable that the rubbing direction, the polarization direction and the direction in which the solution runs off the surface are the same direction.

Furthermore, the orientation step may be a step orienting the monomolecular film completely or partially in one direction, or it may be a step orienting the monomolecular film in different orientation directions at predetermined locations. If the orientation directions are different at predetermined locations, it is preferable to apply rubbing orientation or optical orientation. By applying rubbing orientation, the orientation direction can be made different at predetermined locations.

Furthermore, to perform orientation with different orientation directions at predetermined locations by applying optical orientation, it is possible to irradiate first polarized light through a first photomask on which a predetermined pattern is formed, and then to irradiate second polarized light whose polarization direction is different from the polarization direction of the first polarized light through a second photomask on which a predetermined pattern is formed that is different from the pattern of the first photomask. Furthermore, it is possible to form a complex orientation pattern by using a plurality of photomasks with different patterns and a plurality of kinds of polarized light with different polarization directions.

Also, by irradiating polarized light onto the monomolecular film in a scanning fashion while changing the polarization direction, it is not only possible to form conductive networks that are linked linearly, but also conductive networks that are linked in curves.

Next, in the conductive region formation step, it is possible to form conjugated systems by polymerizing or crosslinking the molecules constituting the monomolecular film to one another. As polymerization method electrolytic polymerization is applied.

It is also possible to form the conductive network by performing the step of polymerization or crosslinking several times. For example, if for the film material molecules organic molecules there are used those that have a plurality of conjugated polymerizable functional groups (polymerizable functional groups that can be polymerized by conjugated bonds), then it is possible to form conjugated systems (chains of conjugated bonds) on a plurality of parallel planes included within the monomolecular layer.

Furthermore, when performing the polymerization or the crosslinking a plurality of times, the polymerization method or the polymerization conditions may differ each time. Here, polymerization conditions means the reaction conditions. For example, in electrolytic polymerization, it means that the applied voltage or the like may differ.

Moreover, the conductive region formation step may be a step in which a conductive region is formed on the entire monomolecular film or on a portion thereof, and it may also be a step in which a plurality of conductive regions that are electrically isolated from one another are formed. In the following explanation the conjugated polymerizable functional groups included in the film material molecules are electrolytically polymerizable functional groups.

Following the case that the organic molecules constituting the monomolecular film have electrolytically polymerizable functional groups is explained. A conductive network that is linked in a predetermined direction can be formed by bringing the monomolecular film in contact with a pair of electrodes having a potential difference. Consequently, a pair of electrolytic polymerization electrodes may be formed that contact the surface or the side faces of the monomolecular film and are arranged at a certain distance from one another, and a voltage may be applied between the formed pair of electrodes. Or, a pair of external electrodes may be brought into contact with the surface or the side faces of the monomolecular film at a certain distance from one another, and a voltage may be applied to the pair of external electrodes.

Moreover, to form a plurality of conductive regions that are electrically insulated from one another, it is possible to form conductive regions between electrodes of different potential by forming a plurality of electrode pairs into a predetermined pattern, and applying predetermined potentials to the electrodes. In this case, conductive regions may be formed one by one by applying a potential to only two electrodes, or conductive regions may be formed simultaneously by applying a potential to three or more electrodes.

Thus, when electrolytic polymerization is performed by forming electrodes, a monomolecular film having conductive regions with terminals can be manufactured. If unnecessary, then these electrodes can be removed.

The polymerization speed of electrolytic is not that high, but the polymerization takes place while letting a current flow, so that in the moment the network is completed, a large current flows, which makes it easy to detect whether it has been concluded or not.

Next, in the doping step, the conductance easily can be increased by doping with a dopant having carrier mobility. The dopant may be an acceptor dopant (electron acceptor) such as iodine (I₂) or BF⁻ ions, or a donor dopant (electron donor) such as Li.

Next, in a substrate material insulation film formation step, an insulating coating such as a silica film or aluminum oxide can be formed on the substrate. In order to use it for a transparent electrode, it is necessary to form a transparent coating. Moreover, when a coating is formed, as an insulating coating to which the film-constituting molecules are easily chemically adsorbed, then a monomolecular film can be formed regardless of the nature of the substrate material.

Lastly, in a protective film formation step, an insulating protective film is formed on the monomolecular film surface. If a protective film formation step is carried out, then it is possible to form a monomolecular film that has excellent durability properties, such as peeling resistance. Moreover, if the monomolecular film includes a dopant, then evaporation of the dopant by undoping can be reduced. Moreover, when used as a transparent electrode or the like, a transparent protective film should be formed.

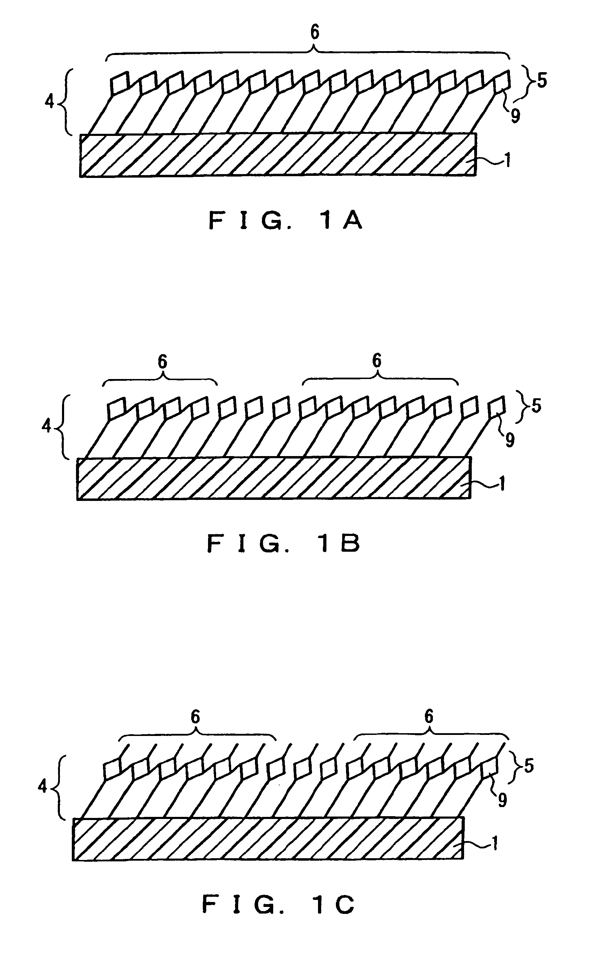

Figs. 1A to 1C show a manufacturing example of a monomolecular film having a conductive region formed with this manufacturing method. Figs. 1A to 1C are cross-sectional drawings schematically showing a monomolecular film having a conductive region, formed on the substrate material. In Fig. 1A, the monomolecular film 4 is fastened to the surface of the substrate material 1 by covalent bonding. As shown, the conjugated polymerizable functional groups 9 are polymerized, and a conductive region 6 is formed across the entire region, forming a conductive network 5. Fig. 1B shows a monomolecular film in which the conductive network 5 has been formed in a plurality of regions (conductive regions 6). Fig. 1C shows a monomolecular film that is made of organic molecules having conjugated polymerizable functional groups inside, in which the conductive network is formed in a plurality of regions (conductive regions 6).

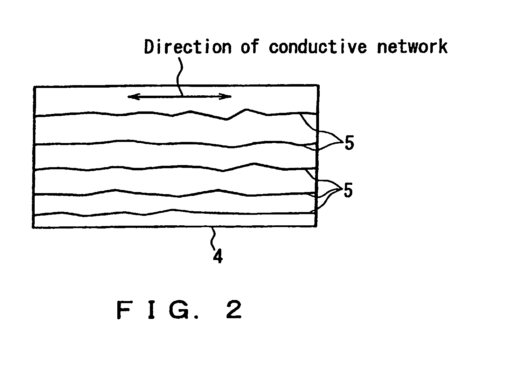

Fig. 2 is a schematic plan view illustrating the direction of the conductive network in the monomolecular film 4. It should be noted that in the drawings other than Fig. 2, meandering conductive networks are expressed as not meandering straight lines or as not meandering curves.

Furthermore, Figs. 3A to 3D show pattern examples of conductive regions in monomolecular films having a conductive region. Figs. 3A to 3D are plan views schematically illustrating conventional examples of conductive regions 6 of the monomolecular layer including a conductive network formed on the substrate material. Fig. 3A shows a monomolecular layer 4, in which a conductive network 5 linked in one direction is formed across the entire region. Fig. 3B shows a monomolecular layer 4 having parallel conductive regions 6, each conductive region 6 provided with a conductive network 5 that is linked in one direction. Fig. 3C shows a monomolecular layer 4 having conductive regions 6 arranged in a matrix, each conductive region being provided with a conductive network 5 that is linked in one direction. Fig. 3D shows a monomolecular layer 4 having conductive regions 6 arranged in desired patterns, wherein the directions of the conductive networks formed in each of the conductive regions are not the same, and also the shapes of the conductive regions are not the same.

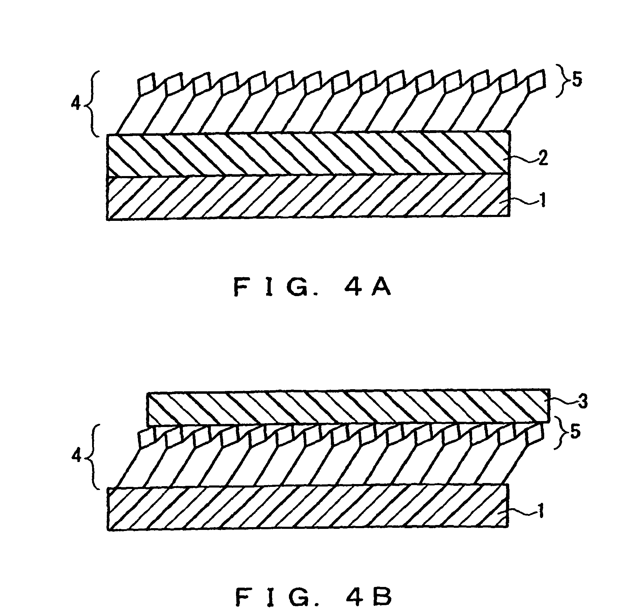

Moreover, Figs. 4A and 4B show the configuration of monomolecular films having a conductive region formed on a substrate material. Figs. 4A and 4B are cross-sectional views schematically showing configuration examples of a monomolecular film formed on a substrate material. Fig. 4A shows a monomolecular film formed on a substrate material 1 with a substrate material insulating film 2, and Fig. 4B shows a monomolecular film formed on the substrate material 1 and provided with a protective film 3 at its surface. Although not shown in the figures, it is also possible to provide a structure in which an insulating film, a monomolecular film and a protective film are formed in that order on the surface of a substrate material.

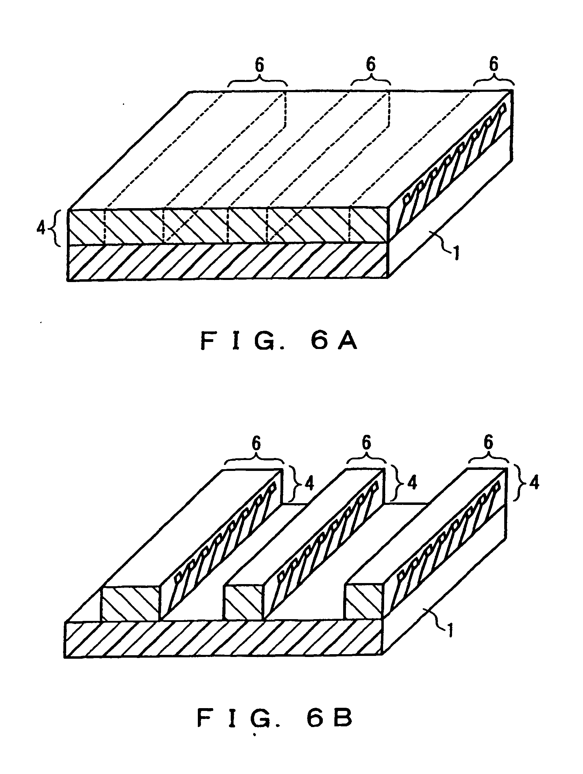

Moreover, Figs. 6A and 6B are perspective views schematically showing configuration examples, in which the conductive regions are formed selectively on a substrate material. Fig. 6A shows a configuration, in which a plurality of conductive regions 6 have been formed in a monomolecular film 4 formed at all locations on a substrate material 1. Fig. 6B shows a configuration, in which a plurality of monomolecular films 4 provided with conductive regions 6 across the entire region have been formed on the substrate material 1.

### Embodiment 2

This Embodiment 2 explains an example of a monomolecular built-up film having conductive regions.

To form a monomolecular built-up film, a first layer is formed by chemisorption. The second and further layers may be formed by chemisorption, but it is also possible to apply the Langmuir-Blodgett method. However, to form a monomolecular layered film by chemisorption on the entire layer is simple and thus preferable. Moreover, the orientation processing step (tilt processing step) has been explained also for Embodiment 1, and in the case of a monomolecular built-up film, it is even more important than in the case of a monomolecular film. The following explains a manufacturing method including an orientation processing step.

In the method for manufacturing a monomolecular built-up film having a conductive region in accordance with the present invention, it is possible to perform a monomolecular layer formation step, a conductive region formation step, and an orientation processing step in various combinations and orders. The following is an explanation of Manufacturing Methods 1 to 5, which are preferable manufacturing methods.

Manufacturing Method 1 is a manufacturing method in which a monomolecular built-up film having a conductive region is formed by performing a monomolecular layer formation step several times in succession, and then performing a conductive region formation step.

Manufacturing Method 2 is a manufacturing method in which a monomolecular built-up film having a conductive region is formed by carrying out a monomolecular layer formation step and an orientation processing step (tilt processing step) several times in alternation to layer oriented monomolecular layers, and then performing a conductive region formation step.

Manufacturing Method 3 is a manufacturing method in which a monomolecular built-up film having a conductive region is formed by carrying out a monomolecular layer formation step, an orientation processing step (tilt processing step) and a conductive region formation step several times in that order.

Manufacturing Method 4 is a manufacturing method in which a monomolecular built-up film having a conductive region is formed by carrying out a monomolecular layer formation step, an orientation processing step (tilt processing step) and a conductive region formation step in that order to form a monomolecular film having a conductive region, then carrying out a monomolecular layer formation step several times in succession, and thereafter performing a conductive region formation step.

Manufacturing Method 5 is a manufacturing method in which after carrying out a preprocessing step, a monomolecular built-up film having a conductive region is formed by carrying out a monomolecular layer formation step several times in succession, and thereafter performing a conductive region formation step. Moreover, manufacturing methods in which any of the Manufacturing Methods 1 to 5 is performed after carrying out a preprocessing step are also preferable.

Which of these Manufacturing Methods 1 to 5 is superior depends on what kind of conductive region pattern is formed on the monomolecular built-up film with conductive region, what orientation method is applied for the orientation processing step, what polymerization method is applied for the conductive region formation step, and so forth. Consequently, it is important to select the optimal manufacturing method for forming the desired monomolecular built-up film with conductive region.

The Manufacturing Methods 1 to 5 also can include one or a plurality of a substrate material insulation film formation step, a washing step, a doping step, and a protective film formation step. The details of the monomolecular layer formation step, the conductive film formation step, the preprocessing step, the orientation step, the substrate material insulating film formation step, the washing step, the doping step and the protective film formation step are described in Embodiment 1. The following is an explanation of the differences of the steps that arise depending on whether the organic thin film is a monomolecular film or a monomolecular built-up film.

A monomolecular built-up film made of one type of organic molecules may be formed using the same film material molecules in the monomolecular layer formation steps, or a monomolecular built-up film in which the constituent molecules differ at each monomolecular layer may be formed using different film material molecules in the monomolecular layer formation steps.

The following is an explanation of the applicability of rubbing orientation and optical orientation in the orientation processing step. In the monomolecular layer formation step applying the Langmuir-Blodgett method, the substrate material ordinarily is lifted out of a solution including the film-constituting molecules at a right angle with respect to the solution surface, so that the orientation is carried out by letting the solution run off in the monomolecular layer step.

The rubbing orientation method is a method in which the organic molecules constituting the film are oriented by rubbing the film surface, so that if it is applied to a monomolecular built-up film with many layers, then the lower layers near the substrate material cannot be sufficiently oriented. Consequently, rubbing orientation is suitable if the manufacturing methods 2 to 4 are applied. It should be noted that if a monomolecular built-up film with few layers is formed using Manufacturing Method 1, then it is possible to use rubbing orientation.

On the other hand, optical polymerization also can be applied to monomolecular built-up films with many layers, so that it is suitable for any of the Manufacturing Methods 1 to 5. However, when the number of layers becomes too large and the optical transparency becomes poor, then the lower monomolecular layers near the substrate material cannot be oriented sufficiently.

Next, electrolytic polymerization, in the conductive region formation step is explained with a preferable manufacturing method.

When electrolytic polymerization is applied, and a voltage is applied to the pair of electrodes in contact with the surface of the monomolecular built-up film, then it becomes difficult to form a conductive network in which the inside of the lower monomolecular layers near the substrate material is sufficiently polymerized, so that it is preferable to apply the voltage to electrodes that are in contact with the lateral faces of the monomolecular built-up film. Thus, if a voltage is applied to electrodes in contact with the lateral faces, then a conductive network can be formed in the monomolecular layers of the monomolecular built-up film when using any of the Manufacturing Methods 1 to 5. Furthermore, the electrolytic polymerization method is suitable for the case that the conductive region is formed across the entire surface of the monomolecular built-up film, and the case that the conductive region passes through the entire monomolecular built-up film.

Next, it is preferable that the washing step is performed only after the monomolecular layer formation step for the lowermost layer near the substrate material, because if the washing step is carried out after the layering of the monomolecular layer, then the layered monomolecular layers may peel off. Moreover, if chemisorption is used to form the lowermost monomolecular layer, then it is preferable that a washing step is performed.

Next, it is preferable that the doping step is performed individually for each monomolecular layer provided with a conductive network. Consequently, when performing a doping step, it is preferable that Manufacturing Method 3 is used, and it is preferable that it is carried out after each conductive region formation step of Manufacturing Method 3.

Examples of structures of conductive regions of monomolecular built-up films formed with these manufacturing methods are shown in Figs. 7A to 7D. It is preferable that the patterns of the conductive regions of the monomolecular layers of the monomolecular built-up films having a conductive region are the same for all monomolecular layers. Fig. 7A to 7D are cross-sectional views schematically showing examples of the layering structure of the monomolecular built-up film formed on the substrate 1. Fig. 7A shows an X-type monomolecular built-up film in which the orientation direction of all monomolecular layers 4 is the same. Fig. 7B shows a Y-type monomolecular built-up film in which the orientation direction of all monomolecular layers 4 is the same. Fig. 7C shows an X-type monomolecular built-up film in which the orientation direction is different for each monomolecular layer 4. Fig. 7D shows an X-type monomolecular built-up film in which all monomolecular layers 4 are oriented in one of two orientation directions.

Instead of the monomolecular film in Fig. 4 and Fig. 6, it is also possible to adopt a structure provided with a monomolecular built-up film.

### Embodiment 3

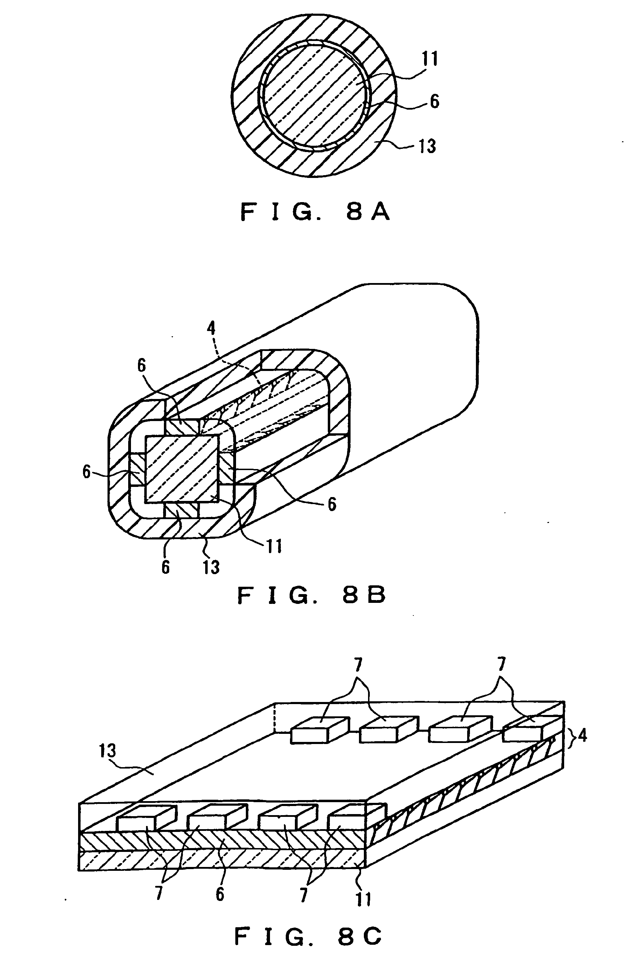

An electric cable in accordance with this embodiment is explained with reference to Figs. 8A to 8C. Figs. 8A to 8C are diagrams schematically showing examples of the structure of electric cables using a conductive region provided with a monomolecular film as the core. Fig. 8A is cross-sectional view of an electric cable provided with a conductive monomolecular film 6 that is formed on an outer surface of a core 11 made of glass or metal, and in which the entire region is taken as the conductive region. The surface of the conductive monomolecular film is covered with an electrically insulating film 13. Fig. 8B is a perspective view of an aggregate conductor-type electric cable, provided with a monomolecular film 4 having four conductive regions formed on the surface of a quadratic prism-shaped insulating base material 11 and covered with an insulating protective film 13 on the outer surface side. Fig. 8C is a perspective view of an aggregate electrode-type flat cable provided with a monomolecular film 4 whose entire region serves as the conducting region 6 formed on a substrate, and four pairs of contact points 7. It should be noted that when the conductive region of the organic thin film has high electric anisotropy, then the flat cable of Fig. 8C becomes a flat cable provided with four core conductors.

Furthermore, it is also possible to provide an aggregate electrode-type flat cable by providing the organic thin film 4 having conductive regions 6 formed on an insulating substrate material 1, as shown in Figs. 6A and 6B, with an insulating protective film.

### Embodiment 4

The organic thin film of the present invention can be used to provide various devices, utilizing it for conductors, aggregate wiring, electrodes or transparent electrodes. For example, it can be used to provide electronic devices such as semiconductor elements, capacitors and semiconductor devices, or optical devices such as liquid crystal display devices, electroluminescent elements or solar cells.

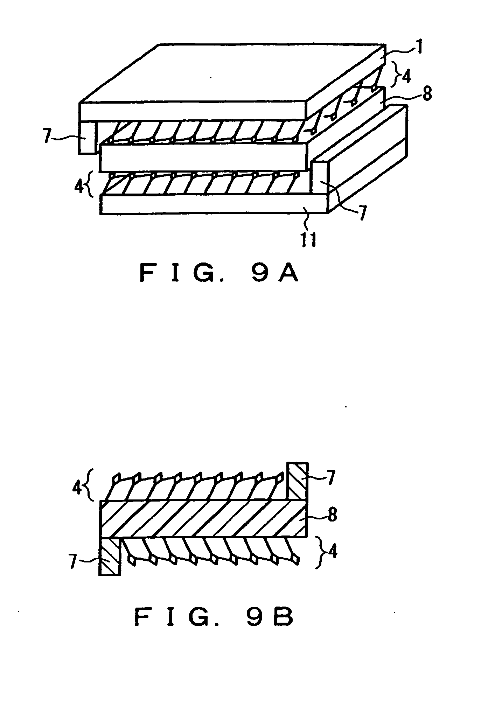

For example, Figs. 9A and 9B are cross-sectional views schematically showing examples of the structure of capacitors using a conductive region formed in a monomolecular film as an electrode. Fig. 9A shows a structure in which a dielectric 8 is sandwiched by two substrate materials 1 provided with monomolecular films 4 having a conductive region 6, wherein the monomolecular films 4 are arranged on the inner side. Fig. 9B shows a structure in which monomolecular films 4 having a conductive region 6 are formed on two parallel surfaces of a dielectric 8. In Fig. 9A and Fig. 9B, when the conductive regions 6 are provided with metal contacts 7 (wiring, lead lines) in a direction that is perpendicular to the direction of the conductive network, then a uniform voltage can be applied to the entire surface of the organic thin film electrodes, which is preferable.

For the pyrrole compound of the present invention it is possible to synthesize a 1-pyrrolylalkyl trichlorosilane with a step of synthesizing a 1-pyrrolylalkyl by reacting, for example pyrrole and terminal bromo 1-alkyl, and reacting the synthesized 1-pyrrolakyl and trichlorosilane. In the case of alkyl 1-pyrrolylalkyl trichlorosilane, it is possible to perform a step of synthesizing an alkyl 1-pyrrolylalkyl by reacting, for example an alkyl pyrrole and a terminal bromo 1-alkyl, and reacting the synthesized alkyl 1-pyrrolakyl and trichlorosilane. Thienyl compounds can be synthesized in the same manner.

### Working Examples

The following is a more specific explanation of the present invention with reference to working examples. In the following working examples, figures given simply in % mean mass %.

### Working Example 1

### [1] Synthesis Step 1 Synthesis of 11-(1-pyrrolyl)-1-undecene

In accordance with the reaction formula shown in the chemical formula (E) below, 38.0 g (0.567 mol) pyrrole and 200 ml dehydrated tetrahydrofuran (THF) were put into a 2L reaction vessel under an argon stream, and were cooled to below 5°C.

To this, 354 ml (0.567 mol) of a 1.6 M solution of n-butyllithium hexane were dripped at a temperature not higher than 10°C. After stirring at the same temperature for one hour, 600 ml dimethylsulfoxide were added, the THF was distilled by heating, and thus the solvent was replaced. Next, 145.2 g (0.623 mol) 11-bromo-1-undecene was dripped in at room temperature. After the dripping, the mixture was stirred at the same temperature for two hours.

Then, 600 mol water were added to the reaction mixture, hexane was extracted, and the organic layer was washed with water. After drying with sulfuric anhydrite magnesium, the solvent was removed.

Furthermore, the residue was purified in a silica gel column with hexane / ethyl acetate = 50/1, and 113.2 g of 11-(1-pyrrolyl)-1-undecene were obtained.

### Reaction Formula 1.

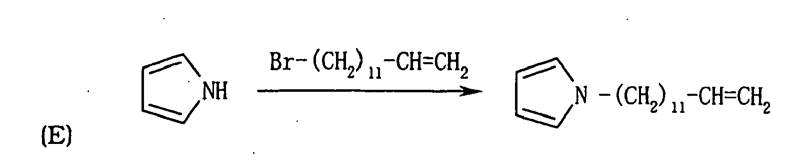

The yield was 91.2%.

It should be noted that also when using ingredients in which the third position of the pyrrolyl group is substituted by an alkyl group or an alkyl group that includes an unsaturated group such as a vinyl group or an ethynyl group, as noted as (a) to (e), and includes an ester as noted as (f) in the following Formula 12, 11-(1-pyrrolyl)-1-undecenes in which the third position of the pyrrolyl group is alkylated or partially alkylated were obtained.
(a) CH₃-(CH₂)₅-
(b) CH₃-(CH₂)₇-
(c) CH₃-(CH₂)₉-
(d) CH₂=CH-(CH₂)₆-
(e) (CH₃)₃Si-C≡C-(CH₂)₆-
(f) CH₃-COO-(CH₂)₄-

### [2] Synthesis Step 2 Synthesis of 11-(1-pyrrolyl)-undecenyl trichlorosilane

In accordance with the Reaction Formula 2 shown in the Chemical Formula (F) below, the reactions (1) to (8) were carried out.

### Reaction Formula 2.

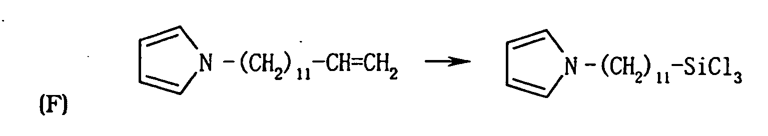

(1) 2.0 g (9.1 × 10⁻³ mol) of 11-(1-pyrrolyl)-1-undecene, 2.0 g (1.48 × 10⁻² mol) of trichlorosilane, and 0.015g AIBN were put into a 50 ml capped pressure-resistant test tube and reacted for five hours at 80°C.
   After this, when a reaction check was performed by NMR, it was found that almost no reaction had taken place.
   Then, a further 2.0 g (1.48 × 10⁻² mol) of trichlorosilane, and 0.015 g AIBN were added, and a reaction was carried out for 22 hours at 100°C.
   When checking the reaction, it was found that the reaction had proceeded to about 50%.
(2) 2.0 g (9.1 × 10⁻³mol) of 11-(1-pyrrolyl)-1-undecene, 2.0 g (1.48 × 10⁻² mol) of trichlorosilane, and 0.01 g of a 5% isopropyl alcohol solution of H₂PtCl₆ · 6H₂O were put into a 50 ml capped pressure-resistant test tube and reacted for nine hours at 50°C. When checking the reaction by NMR, it was found that the reaction had proceeded to about 50%.
   After that, the mixture was reacted overnight at the same temperature, but the reaction did not proceed further.
(3) 2.0 g (9.1 × 10⁻³ mol) of 11-(1-pyrrolyl)-1-undecene and 0.01 g of a 5% isopropyl alcohol solution of H₂PtCl₆ · 6H₂O were put into a 30 ml reaction vessel equipped with a reflux condenser and a dropping funnel, and heated to 70°C. To this, 1.49 g (10 × 10⁻² mol) of trichlorosilane were dripped over two hours at 60 to 70°C.
   Thereafter, the mixture was reacted for two hours at the same temperature.
   When checking the reaction by NMR, it was found that the reaction had proceeded to about 50%.
   After that, the mixture was reacted overnight at the same temperature, but the reaction did not proceed further.
(4) 10.0 g (4.57 × 10⁻² mol) of 11-(1-pyrrolyl)-1-undecene and 0.05 g of a 5% isopropyl alcohol solution of H₂PtCl₆ · 6H₂O were put into a 50 ml reaction vessel equipped with a reflux condenser and a dropping funnel, and heated to 70°C. To this, 7.45 g (5.50 × 10⁻² mol) of trichlorosilane were dripped over four hours at 60 to 70°C.
   Thereafter, the mixture was reacted for six hours at the same temperature. When checking the reaction by NMR, it was found that the reaction had proceeded to about 50%.
   After that, 0.05 g of the 5% isopropyl alcohol solution of H₂PtCl₆ · 6H₂O were added and the mixture was reacted at the same temperature over night, but the reaction did not proceed further.
   To this mixture, 7.45 g (5.50 × 10⁻² mol) of trichlorosilane were dripped over four two at 60 to 70°C. Then, the inner temperature was reduced to 50°C in order to reflux the trichlorosilane. It should be noted that even when reacting for six hours after the dropping, it was found that the reaction did not proceed.
   Then the mixture was moved to a 50 ml capped pressure-resistant test tube and reacted overnight at 100°C, but there was no change.
   4.0 g of 11-(1-pyrrolyl)-undecenyl trichlorosilane were obtained by distilling the mixture under reduced pressure.
   In this case, the bp of the resulting substance was 119 to 121°C/5.32 Pa (0.04 mmHg), and the yield was 24.7%.
(5) 10.0 g (4.57 × 10⁻² mol) of 11-(1-pyrrolyl)-1-undecene, 10.0 g (7.38 × 10⁻² mol) trichlorosilane and 0.05 g of a 5% isopropyl alcohol solution of H₂PtCl₆ · 6H₂O were put into a 50 ml capped pressure-resistant test tube, and heated to 100°C for three hours. When checking the reaction by NMR, it was found that the reaction had proceeded to about 50%. After that, the mixture was reacted overnight at the same temperature, but the reaction did not proceed further.
(6) 67.0 g (3.06 × 10⁻¹ mol) of 11-(1-pyrrolyl)-1-undecene and 0.34 g of a 5% isopropyl alcohol solution of H₂PtCl₆ · 6H₂O were put into a 50 ml reaction vessel equipped with a reflux condenser and a dropping funnel, and heated to 70°C. To this, 50.0 g (3.69 × 10⁻¹ mol) of trichlorosilane were dripped over two hours at 60 to 70°C. After that, the mixture was reacted at the same temperature for three hours. When checking the reaction by NMR, it was found that the reaction had proceeded to about 40%. After that, the mixture was reacted overnight at the same temperature, but the reaction did not proceed further.
   (5) and (6) were distilled together under reduced pressure, and 26.9 g of 11-(1-pyrrolyl)-undecenyl trichlorosilane were obtained. In this case, the bp of the resulting substance was 121 to 123°C/6.65 Pa (0.05 mmHg), and the yield was 21.6%.
(7) 80.0 g (3.65 × 10⁻¹ mol) of 11-(1-pyrrolyl)-1-undecene and 0.41 g of a 5% isopropyl alcohol solution of H₂PtCl₆ · 6H₂O were put into a 50 ml reaction vessel equipped with a reflux condenser and a dropping funnel, and heated to 70°C. To this, 60.0 g (4.42 × 10⁻¹ mol) of trichlorosilane were dripped over two hours at 60 to 70°C. After that, the mixture was reacted overnight at the same temperature. When checking the reaction by NMR, it was found that the reaction had proceeded about 30%.
   Then it was distilled under reduced pressure, and 17.0 g of 11-(1-pyrrolyl)-undecenyl trichlorosilane were obtained. In this case, the bp of the resulting substance was 129 to 132°C/33.25 Pa (0.25 mmHg), and the yield was 13.1%.
(8) 45.0 g (2.05 × 10⁻¹ mol) of 11-(1-pyrrolyl)-1-undecene, 25.0 g (1.85 × 10⁻¹ mol) trichlorosilane, and 0.23 g of a 5% isopropyl alcohol solution of H₂PtCl₆ · 6H₂O were put into a 100 ml capped pressure-resistant test tube, and reacted for 12 hours at 100°C. When checking the reaction by NMR, it was found that the reaction had proceeded about 50%.

Then it was distilled under reduced pressure, and 14.7 g of 11-(1-pyrrolyl)-undecenyl trichlorosilane were obtained. In this case, the bp of the resulting substance was 124 to 125°C/13.3 Pa (0.1 mmHg), and the yield was 22.4%.

It should be noted that in reactions (7) and (8), the reaction was carried out using recovered ingredients.

As described above, eight types of synthesis conditions were studied for the synthesis method of Step 2, and in each one of these, the yield was 20 to 25%. However, with the method of dropping trichlorosilane using recovered ingredients, the yield was only 13%. Moreover, it seems that when the scale of the dripping method was enlarged, the reaction rate decreased.

Judging by the above results, it seems that the reaction conditions (2) or (8) are best, considering the inserted amounts, the reaction times and so forth.

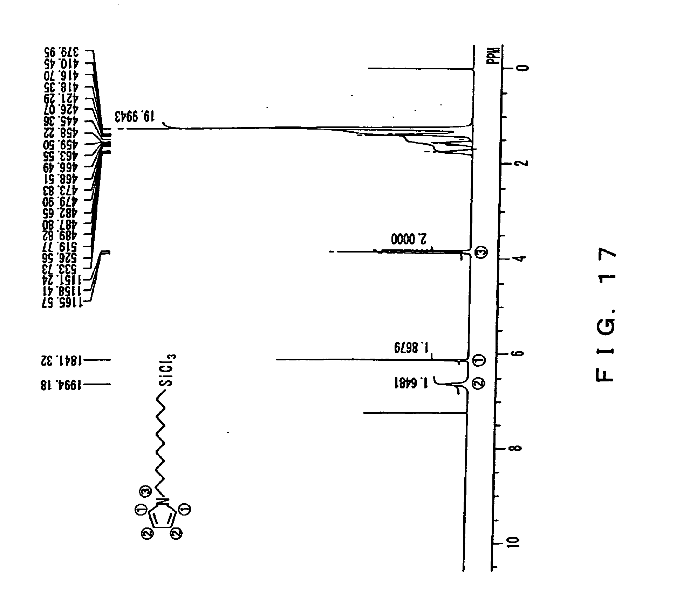

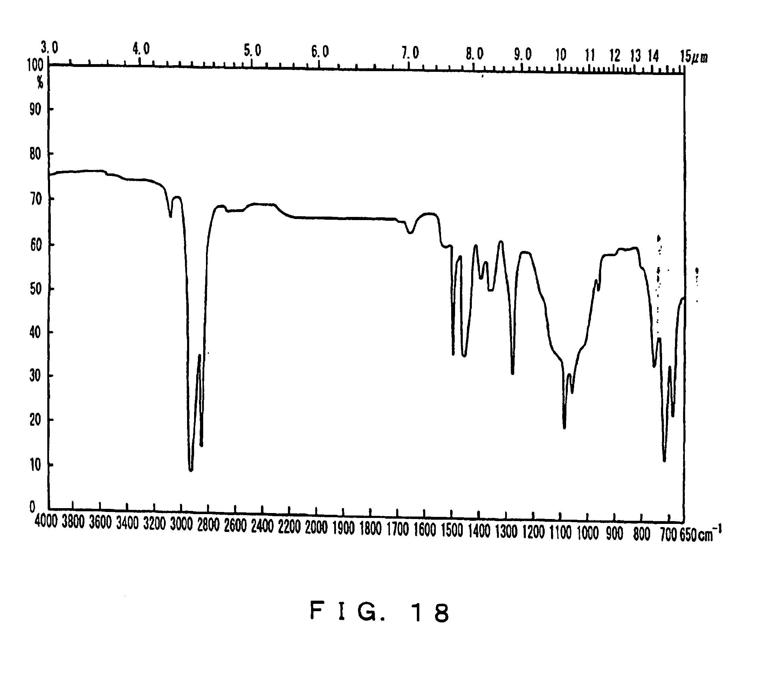

Fig. 17 shows an NMR chart and Fig. 18 shows an IR chart of the resulting product. For the NMR, an AL 300 (300 Hz) by JEOL Ltd. was used, and the samples were dissolved in 30 mg CDCl₃ and measured. For the IR, an A-100 by JASCO Corp. was used, and the measurement was performed by the neat method (measuring the sample between two sheets of NaCl).

Here, also when using as ingredients alkylated or partially alkylated 11-(1-pyrrolyl)-1-undecene obtained in the Synthesis Step 1, in which the third position of the pyrrolyl group is substituted by an alkyl group that includes an unsaturated group such as a vinyl group or an acetylene group at its end, alkylated or partially alkylated 11-(1-pyrrolyl)-1-undecenyl trichlorosilanes were obtained.

A chemisorptive solution was prepared by diluting the 11-(1-pyrrolyl)-undecenyl trichlorosilane obtained by the Reaction Formula 2 (Chemical Formula (F)) and shown in the Chemical Formula (G) below to 1% in a dehydrated dimethyl silicone solvent.

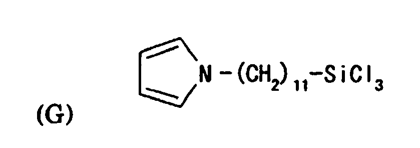

Furthermore, an electrically insulating silica film 2 of 0.5 µm thickness was prepared on the surface of an electrically insulating polyimide substrate of 0.2 mm thickness, as shown in Fig. 10A.

Next, the polyimide substrate 1 was immersed in the chemisorptive solution to chemisorb the chemisorptive molecules to the surface of the silica film 2 (monomolecular layer formation step). After the monomolecular layer formation step, the polyimide substrate 1 was immersed in a chloroform solution to wash off unreacted film material molecules remaining on the polyimide substrate 1. Thus, a monomolecular film 14 was formed without defects on its surface (Fig. 10A).

At this time, there are numerous hydroxyl groups including active hydrogen at the surface of the silica film 2 on the polyimide substrate 1, so that a monomolecular film 14 constituted by the chemisorptive molecules shown in Chemical Formula (H) is formed by chemical bonding with covalent bonds due to a dechlorination reaction between these hydroxyl groups and the -SiCl bond groups of the chemisorptive molecules. It should be noted that Chemical Formula (H) shows the case in which all of the -SiCl bond groups in the chemisorptive molecules have reacted with the surface of the silica film 2, but it is sufficient if at least one of the -SiCl bond groups reacts with the surface of the silica film 2.

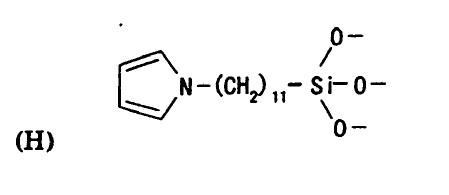

Next, the surface of the formed monomolecular film 14 is subjected to a rubbing process using a rubbing device (Fig. 5A) as used for the production of liquid crystal orientation films, and the chemisorptive molecules constituting the monomolecular film 14 are oriented (tilt processing step) (Fig. 10B). In the rubbing process, rubbing was carried out using a rubbing roll 42 of 7.0 cm diameter around which a rubbing cloth 41 made of rayon is wrapped and at the conditions of an indentation depth of 0.3 mm, a nip width of 11.7 mm, a rotation speed of 1200 rotations/sec, and a table speed (substrate feed-forward speed) of 40 mm/sec. Thus, a monomolecular film 24 that was oriented (tilted) substantially parallel to the rubbing direction was obtained.

Next, using vapor deposition, photolithography and etching, a pair of platinum electrodes 17 of 50 mm length were vapor deposited on the surface of the monomolecular film 24 at a spacing of 5 mm, the substrate was immersed in super-pure water at room temperature, and a voltage of 8 V was applied for six hours between the pair of platinum electrodes 17, thus performing polymerization through electrolytic oxidation (conductive region formation step). Thus, with Chemical Formula (I) below serving as the polymerization units, a conductive region 16 having a conductive network including a conductive polypyrrole conjugated system linked in a predetermined direction (rubbing direction) could be formed between the pair of platinum electrodes 17 (conductive region formation step) (Fig. 10D).

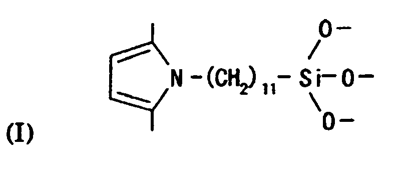

The film thickness of the resulting organic conductive film was about 2.0 nm, and the thickness of the polypyrrole portion was about 0.2 nm.

A current of 1 mA could be caused to flow between the pair of platinum electrodes 17 at a voltage application of 8 V through the organic conductive film. Consequently, a monomolecular film 34 having a conductive region in which the conductance of the conductive network is about 10³S/cm was obtained even without doping with impurities such as donors and acceptors.

The conductance of the thusly formed conductive region is about 1/10 to 1/100 of metal, so that when the monomolecular film 34 was stacked, it was at a level at which it can be used for the wiring or electrodes of functional devices such as semiconductor element or capacitors. Moreover, the monomolecular film 34 of this working example does not absorb light of a wavelength in the visible region, so that when stacked, it was at a level at which it can be used for the transparent electrodes of liquid crystal display elements, electroluminescent elements, solar cells, and so forth.

It should be noted that in this working example, a polyimide substrate 1 whose surface was provided with an insulating silica film 2 was used, but a similar monomolecular film having a conductive region was also obtained when using a polyimide substrate whose surface was provided with an insulating aluminum oxide film. Furthermore, also when using a conductive aluminum substrate instead of the polyimide substrate, a similar monomolecular film having a conductive region could also be obtained by providing a silica film on the substrate surface or subjecting the substrate surface to an oxidation process.

Furthermore, the rubbing orientation was applied in the tilt processing step of this working example, but a monomolecular film having a conductive region with similar conductivity also could be obtained by subjecting the surface of a polyimide substrate provided with a silica film to a rubbing process before the monomolecular layer formation step, and then forming a monomolecular film oriented in the rubbing direction by forming the monomolecular film by the same method, and thereafter forming the conductive region by the same method.

Furthermore, the rubbing orientation was applied in the tilt processing step of this working example, but a monomolecular film 34 having a conductive region with even better conductivity could be obtained by irradiating ultraviolet light through a polarizer 43 to form a monomolecular film 24 in which the chemisorptive molecules 22 constituting the monomolecular film 14 are oriented substantially parallel to the polarization direction, as shown in Fig. 5B (optical orientation), and then forming a conductive region with the same method as above after that. It should be noted that the light used in the optical orientation is not limited to the above-mentioned polarized UV light, and it was also possible to use other light, as long as its wavelength is absorbed by the monomolecular film 34.

Moreover, when the polyimide substrate 1 was lifted out of the chloroform washing solution in the washing step of this working example, and the surface of the polyimide substrate 1 was lifted substantially vertically with respect to the surface of the chloroform washing solution 44, as shown in Fig. 5C, then it was also possible to form a monomolecular film 24 in which the chemisorptive molecules 22 constituting the monomolecular film are oriented substantially parallel to the direction in which the solution runs off (orientation by letting a solution run off). Thus, it is possible to perform the washing step and the tilt processing step simultaneously. Furthermore, when the monomolecular film that was oriented by letting a solution run off was subjected to optical orientation, and then the conductive region was formed by the same method as above, a monomolecular film 34 having a conductive region with a conductance of 10⁴S/cm was obtained.

### Working Example 2

Using 3-hexyl-1-pyrrole octyl trichlorosilane as shown by Chemical Formula (J) below and synthesized with the same method as in Working Example, and diluting it to 1% in an organic solution of dehydrated dimethyl silicone, a chemisorptive solution was prepared.

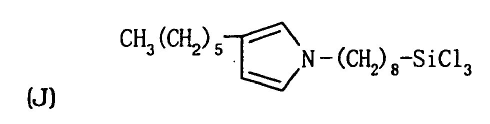

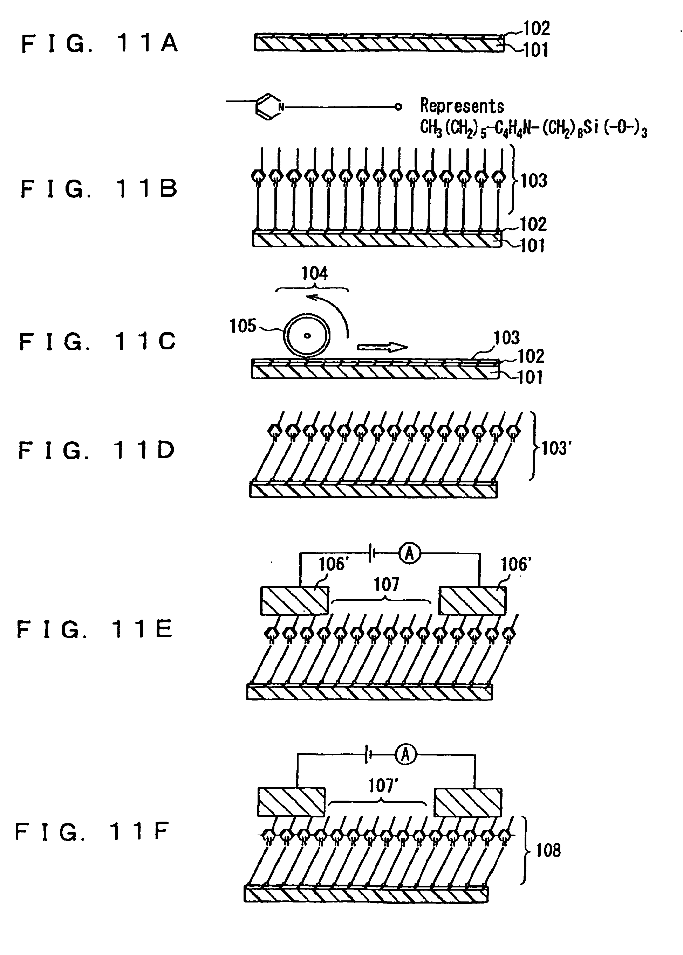

Next, an insulating thin film of 0.5 µm thickness, for example a silica protective film or an Al₂O₃ protective film 102 was formed on the surface of an insulating polyimide substrate 101 (which can be a glass or a conductive metal substrate) of 0.2 mm thickness (Fig. 11A).

Next, the substrate was immersed in the chemisorptive solution and the chemisorptive molecules were chemisorbed to the surface of the silica film, and unreacted material remaining on the surface was washed off with chloroform, thus selectively forming a monomolecular film 103 made of the above-noted substance (Fig. 11B).

At this time, there are numerous hydroxyl groups including active hydrogen present at the substrate surface (silica film or Al₂O₃ film), so that the -SiCl groups of that substance undergo a dehydrochlorination reaction with the hydroxyl groups, and a monomolecular film 103 constituted by the molecules shown in Chemical Formula (K) is formed that is covalently bonded to the substrate surface.

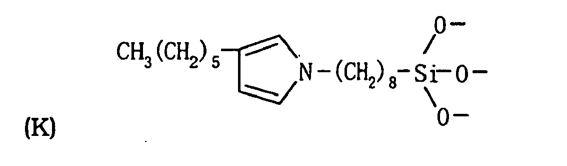

After that, as shown in Fig. 11C, rubbing was performed in a direction substantially perpendicular to the electrode gap using a rubbing device 104 as used for the production of liquid crystal orientation films, with a rubbing cloth 105 made of rayon (YA-20-R made by Yoshikawa Industries Co. Ltd. and at the conditions of an indentation depth of 0.3 mm, a nip width of 11.7 mm, a rotation speed of 1200 r.p.m, and a table speed (substrate feed-forward speed) of 40 mm/sec, thus producing a monomolecular film 103' in which the molecules constituting the monomolecular film are oriented substantially parallel to the rubbing direction (Fig. 11D).

Next, a pair of platinum electrodes (source and drain electrodes) 106 and 106' of 50 mm length were vapor deposited on the monomolecular film surface at a spacing of 5 mm, and a dc electric field of 8V was applied between these electrodes for six hours in super-pure water at room temperature (25°C), thus performing polymerization through electrolytic oxidation of the pyrrolyl groups 107. As a result, the electrodes were connected by conductive polypyrrolyl groups 107' (conjugated bond groups) as shown in Fig. 11E and the below Chemical Formula (L), and a conductive monomolecular film 108 was obtained, in which the conductivity at room temperature (25°) was 4 × 10³S/cm (with this monomolecular film, and a current of 4 mA could be attained when applying an electric field of 8 V) (Fig. 11F).

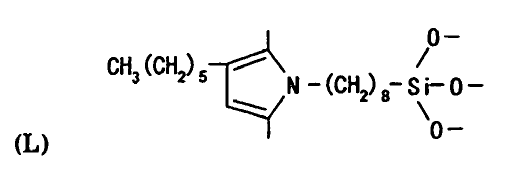

It should be noted that if a larger current capacity is necessary, a conductive monomolecular built-up film could be formed by stacking monomolecular films by repeating a process of using, instead of the above-described substance, a material in which the terminal alkyl groups incorporate unsaturated hydrocarbon groups, for example vinyl groups or acetylene groups as shown in Chemical Formula 12 D or E, transforming them into hydroxyl groups (-OH) by oxidation after chemisorptive reaction and after or before the polymerization, and stacking the next monomolecular film onto these -OH portions.

The conductivity was about 1/10 to 1/100 of metal, so that when stacked, it was at a level at which it can be used for the wiring or electrodes of functional devices such as semiconductor elements or capacitors. Moreover, since the coating is a monomolecular film, the film thickness is extremely thin, namely in the range of nanometers, so that light in the wavelength range of visible light is transmitted with hardly any absorption. Therefore, it was at a level at which it can be used for transparent electrodes of liquid crystal display elements, electroluminescent elements, solar cells, and so forth.

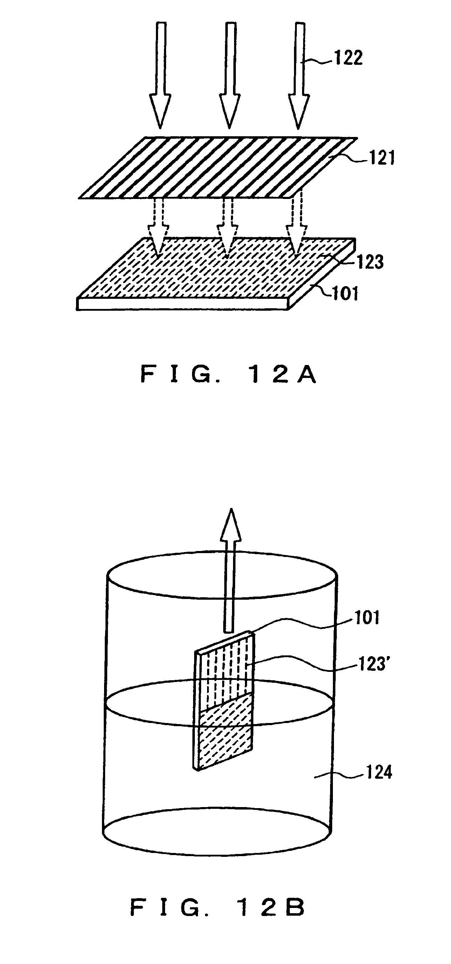

It should be noted that here, if UV light 122 was irradiated through the polarizer 121 when orienting the molecules constituting the monomolecular film (Fig. 12A), then a monomolecular film was obtained in which the molecules 123 constituting the monomolecular film were oriented substantially parallel to the polarization direction, and after that, a conductive monomolecular film with superior conductivity was obtained by polymerizing with the same method as above.

For the light used for the optical polymerization, it was possible to use polarized UV light or visible light, as long as the light had a wavelength that is absorbed by the monomolecular film.

Moreover, when, after the formation of the monomolecular film, the monomolecular film was again immersed in chloroform serving as a washing solution 124, the same washing was performed, and the substrate was lifted out upright while letting the solution run off it, then a monomolecular film 123' was obtained in which the molecules constituting the monomolecular film were oriented substantially parallel to the direction in which the solution ran off, and when thereafter polymerization through electrolytic oxidation was performed with the same method as above, then a conductive monomolecular film with a conductivity of 10⁴ S · cm at room temperature (25°) was obtained (Fig. 12B).

Furthermore, the orientation properties could be improved further by performing a step of lifting the substrate upright and letting the solution run off it, before the optical orientation.

It should be noted that it is also possible to utilize such a coating in place of the indium tin oxide alloy (ITO) transparent electrodes used for electroluminescent (EL) elements or solar cells.

Furthermore, producing a coating of at least 10³ S/cm conductivity in the form of a monomolecular film or a monomolecular built-up film in which a plurality of conductive conjugated bond groups are oriented in a certain direction within the layer, it was possible to utilize it for the electrodes of capacitors, the wiring of semiconductor IC chips or electromagnetic wave shielding films.

### Working Example 3

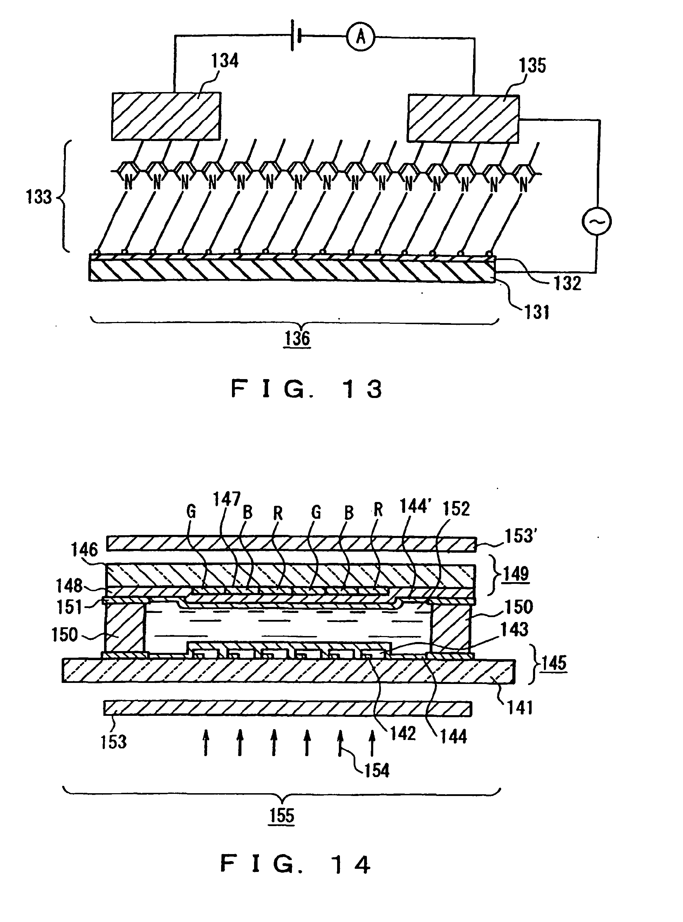

As shown in Fig. 13, a Si substrate 131 (serving as a gate electrode) was used instead of the polyimide substrate 101 in Working Example 1, a silicon dioxide (SiO₂) film 132 was formed instead of the protective film 102, and a similar conductive monomolecular film 133 was formed. Then, a pair of platinum electrodes (serving as a source electrode 134 and a drain electrode 135) were formed at a spacing of 5 µm. Otherwise, the same processes were performed, and a thin-film transistor (TFT) type organic electronic device (three-terminal element) 136 having the SiO₂ film as a gate insulation film was produced (Fig. 13).

In this device, the TFT channel was constituted by polypyrrolyl groups, which are conjugated bond groups in which both ends are bonded to the source and drain electrodes, so that at least several hundred organic TFTs could be easily obtained, in which the mobility due to the electric field effect was about 1000 cm²/V · S.

### Working Example 4

As shown in Fig. 14, a group of three-terminal organic electronic devices 142 was formed and arranged in an array in matrix shape on the surface of an acrylic substrate (of 0.5 mm thickness) by the same process as in Working Example 1. The organic electronic devices are for use as the switches for liquid crystal operation. Then, the electrodes on the source side and on the gate side were connected by source wiring and gate wiring, respectively. Moreover, a transparent electrode 143 was formed using indium-tin oxide (ITO) alloy as the electrode on the drain side.

Next, a polyimide coating was formed on the surface of this array surface by an ordinary method, and an oriented film 144 was formed by rubbing, thus producing an array substrate 145.

On the other hand and in parallel thereto, a color filter was formed by arranging a group of RGB color elements 147 in an array in matrix shape on the surface of an acrylic substrate 146, and a conductive transparent electrode 148 was formed on its surface, thus producing a color filter substrate 149.

Next, a polyimide coating was formed on the surface of this color filter and rubbed, producing an oriented film 144'.

Next, the array substrate 145 on which the oriented film is formed and the color filter substrate 149 were placed on top of one another with the oriented films facing each other, and, spaced apart by spacers 150, glued together with an epoxy-based adhesive 151, except for a sealing port portion. Thus a liquid crystal cell was produced that was sealed at its peripheral edge at a predetermined spacing.

Finally, a TN liquid crystal 152 was filled in and sealed, and an IC chip with peripheral circuitry was installed, and polarizers 153 and 153' were placed at the front and the back, and thus a TN liquid crystal display device 155 incorporating a backlight 154 was manufactured (Fig. 14).

With this method, it is not necessary to heat the substrate during the manufacturing of the array, so that it was possible to manufacture a liquid crystal display device with sufficiently high image quality even when using a substrate with a low glass transition point (Tg), such as an acrylic substrate.

In this case, using a surface active agent including a hydrocarbon group (for example CH₃-(CH₂)₉-Si-Cl₃) as an insulating monomolecular film or an insulating monomolecular built-up film in contact with the gate electrodes of the organic electronic devices, a monomolecular film of CH₃-(CH₂)₉-Si(-O-)₃ was formed by chemisorption. In this case, the voltage resistance could be improved greatly to 0.5 × 10¹⁰V/cm to 1 × 10¹⁰V/cm. The peel-off strength was about 1 ton/cm². Thus, a liquid crystal display device with excellent reliability could be manufactured.

It should be noted that in Working Example 4, an example was illustrated in which a bottom gate liquid crystal display device was produced, but it can also be applied to a top gate liquid crystal display device.

### Working Example 5

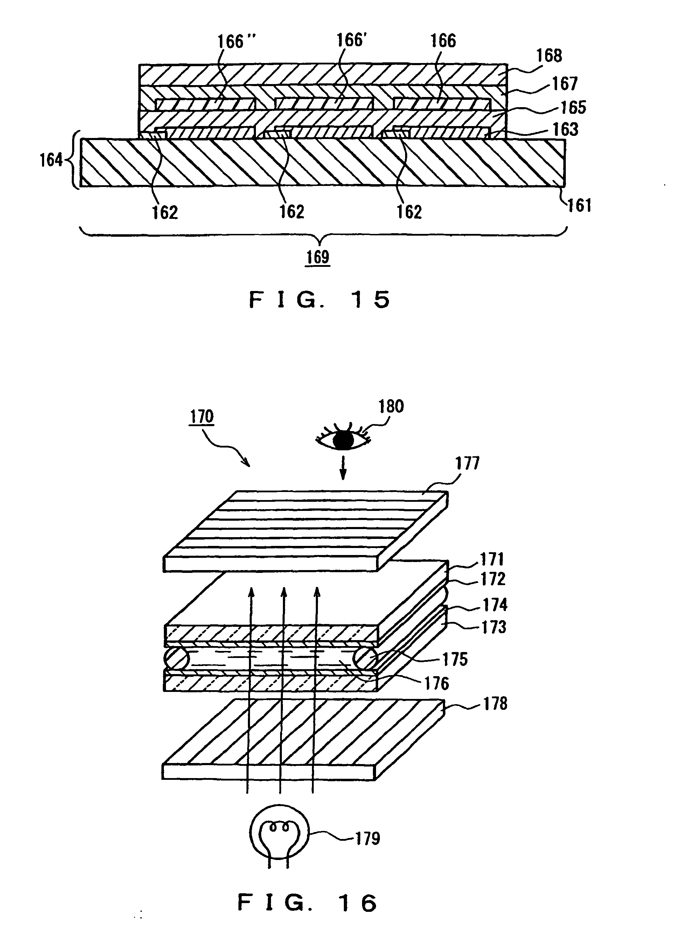

As shown in Fig. 15, a group of three-terminal organic electronic devices 162 to be used as switches for the operation of electroluminescent elements were formed in an array in matrix shape on the surface of a polyether sulphone substrate (of 0.2 mm thickness) by the same process as in Working Example 1. Then, electrodes on the source side and on the gate side were connected by source wiring and gate wiring, respectively. Moreover, transparent electrodes 163 were formed using indium-tin oxide (ITO) alloy as the electrodes on the drain side, thus producing an array substrate 164.

Next, a hole transport layer 165 was vapor deposited on the transparent electrodes 163 connected to the drains of the three-terminal organic electronic devices. A red light-emitting layer 166 (2,3,7,8,12,13,17,18-octaethyl-21H23H-porphin platina(II)), a green light-emitting layer 166' (tris(8-quinolinolato)aluminum) and a blue light-emitting layer 166" (4,4'-bis(2,2-diphenylvinyl)biphenyl) were vapor deposited with masks. Then, an electron transport layer 167 was vapor deposited across the entire surface, and a cathode 168 (made for example of an alloy of Mg and Ag, an alloy of Al and Li or by layering LiF and Al on the electron transport layer 167). Finally, an IC chip incorporating peripheral circuitry was installed, thus manufacturing an EL-type display device 169 (Fig. 15).

When manufacturing the array with this method, it is not necessary to heat the substrate, so that an EL-type display device with sufficiently high image quality could be produced even when using a polyether sulphone substrate.

In this case, when an insulating film was formed on the gate electrode of the organic electronic devices with the surface active agent including hydrocarbon groups used in Working Example 4, then the withstand voltage could be improved greatly to 0.5 × 10¹⁰V/cm to 1 × 10¹⁰V/cm. The peel-off strength was about 1 ton/cm². Thus, a liquid crystal display device with excellent reliability could be manufactured.

Moreover, an electroluminescence color display device could be manufactured by forming, in the step of forming electroluminescence films each connected to the drains of the three-terminal organic electronic devices, three kinds of electroluminescence films that emit red, green and blue light, respectively.

### Working Example 6

This Working Example is about a monomolecular film having a conductive region including a conductive network formed by electrolytic polymerization.

First, a chemisorptive solution of the chemisorptive molecules to be used as the film material molecules shown in Chemical Formula (M), which include pyrrole groups, which are conjugated polymerizable functional groups (functional groups that can be polymerized by conjugated bonds), and trichlorosilyl groups (-SiCl₃) reacting with active hydrogen at the molecule ends, is diluted to 1 wt% in an organic solvent of dehydrated dimethylsilicone. Furthermore, an insulating silica film 2 was prepared on the surface of an insulating polyimide substrate 1.

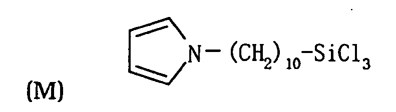

Next, the polyimide substrate 1 was immersed in the chemisorptive solution to chemisorb the chemisorptive molecules to the substrate of the silica film 2 (monomolecular layer formation step). After the monomolecular layer formation step, the polyimide substrate 1 was immersed in a chloroform solution to wash off unreacted film material molecules remaining on the polyimide substrate 1. Thus, a monomolecular film 14 is formed without defects on its surface (Fig. 10A).

At this time, there are numerous hydroxyl groups including active hydrogen at the surface of the silica film 2 on the polyimide substrate 1, so that a monomolecular film 14 constituted by the chemisorptive molecules as shown in Chemical Formula N is formed by chemical bonding with covalent bonds due to a dechlorination reaction between these hydroxyl groups and the -SiCl bond groups of the chemisorptive molecules. It should be noted that Chemical Formula (N) shows the case that all of the -SiCl bond groups in the chemisorptive molecules have reacted with the surface of the silica film 2, but it is sufficient if at least one of the -SiCl bond groups reacts with the surface of the silica film 2.

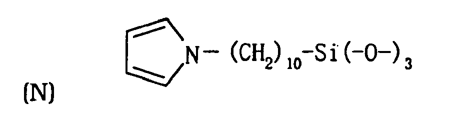

Next, the surface of the formed monomolecular film 14 is subjected to a rubbing process using a rubbing device (Fig. 5A) as used for the production of liquid crystal orientation films, and the chemisorptive molecules constituting the monomolecular film 14 are oriented (tilt processing step) (Fig. 10B). In the rubbing process, rubbing was carried out using a rubbing roll 42 of 7.0 cm diameter around which a rubbing cloth 41 made of rayon is wrapped and at the conditions of an indentation depth of 0.3 mm, a nip width of 11.7 mm, a rotation speed of 1200 rotations/sec, and a table speed (substrate feed-forward speed) of 40 mm/sec. Thus, a monomolecular film 24 that was oriented (tilted) substantially parallel to the rubbing direction was obtained.

Next, using vapor deposition, photolithography and etching, a pair of platinum electrodes 17 of 50 mm length were deposited on the surface of the monomolecular film 24 at a spacing of 5 mm, the substrate was immersed in super-pure water at room temperature, and a voltage of 8 V was applied for six hours between the pair of platinum electrodes 17, thus performing electrolytic polymerization (conductive region formation step). Thus, with Chemical Formula (O) below serving as the polymerization units, a conductive region 6 having a conductive network including conductive polypyrrole conjugated systems linked in a predetermined direction (rubbing direction) could be formed between the pair of platinum electrodes 17 (conductive region formation step) (Fig. 10D).

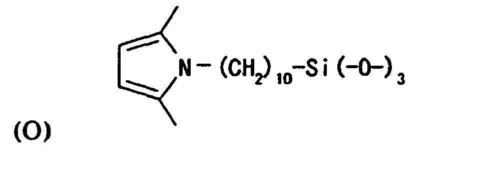

A current of 1 mA could be caused to flow between the pair of platinum electrodes 17 at a voltage application of 8 V. Consequently, a monomolecular film 34 having a conductive region in which the conductance of the conductive network is about 10³S/cm was obtained even without doping with impurities such as donors and acceptors.

The conductance of the thusly formed conductive region is about 1/10 to 1/100 that of metal, so that when the monomolecular film 34 was stacked, it was at a level at which it can be used for the wiring or electrodes of functional devices such as semiconductor element or capacitors. Moreover, the monomolecular film 34 according to this working example does not absorb light of a wavelength in the visible region, so that when stacked, it was at a level at which it can be used for the transparent electrodes of liquid crystal display elements, electroluminescent elements, solar cells, and so forth.

It should be noted that in this working example, a polyimide substrate 1 whose surface was provided with an insulating silica film 2 was used, but a similar monomolecular film having a conductive region was also obtained when using a polyimide substrate whose surface was provided with an insulating aluminum oxide film. Furthermore, also when using a conductive aluminum substrate instead of the polyimide substrate, a similar monomolecular film having a conductive region could be obtained by providing a silica film on the substrate surface or subjecting the substrate surface to an oxidation process.

Furthermore, the rubbing orientation was applied in the tilt processing step of this working example, but a monomolecular film having a conductive region with similar conductivity could also be obtained by subjecting the surface of a polyimide substrate provided with a silica film to a rubbing process before the monomolecular layer formation step, and then forming a monomolecular film oriented in the rubbing direction by forming the monomolecular film by the same method, and thereafter forming the conductive region by the same method.

Furthermore, rubbing orientation was applied in the tilt processing step of this working example, but a monomolecular film 34 having a conductive region with even better conductivity could be obtained by irradiating ultraviolet light through a polarizer 43 to form a monomolecular film 24 in which the chemisorptive molecules 22 constituting the monomolecular film 14 are oriented substantially parallel to the polarization direction, as shown in Fig. 5B (optical orientation), and forming a conductive region with the same method as above after that. It should be noted that the light used in the optical orientation is not limited to the above-mentioned polarized UV light, and it was also possible to use other light, as long as its wavelength is absorbed by the monomolecular film 34.

Moreover, when the polyimide substrate 1 was lifted out of the chloroform washing solution in the washing step of this working example, and the surface of the polyimide substrate 1 was lifted substantially vertically with respect to the surface of the chloroform washing solution 44, as shown in Fig. 5C, then it was also possible to form a monomolecular film 24 in which the chemisorptive molecules 22 constituting the monomolecular film are oriented substantially parallel to the direction in which the solution runs off (orientation by letting a solution run off). Thus, it is possible to perform the washing step and the tilt processing step simultaneously. Furthermore, when a monomolecular film that was oriented by letting a solution run off was subjected to optical orientation, and then the conductive region was formed by the same method as above, a monomolecular film 34 having a conductive region with a conductance of 10⁴S/cm was obtained.

### Working Example 7

11-(3-thienyl)-1-undecene was synthesized by the reaction formula shown in Chemical Formula (P) below in the same manner as in Working Example 1, and 11-(3-thienyl)-1-undecenyl trichlorosilane was synthesized by the reaction formula shown in the following Chemical Formula (Q).

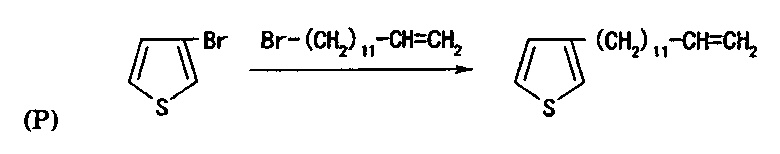

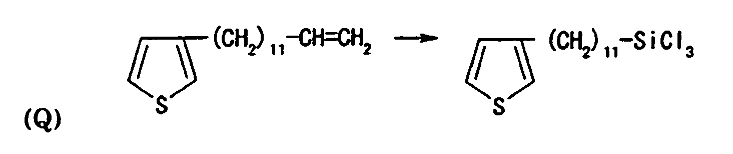

A chemisorptive solution was prepared by diluting the obtained 11-(3-thienyl)-undecenyl trichlorosilane to 1% in a dehydrated dimethylsilicone solvent. A glass substrate of about 3 mm thickness was immersed in this chemisorptive solution and kept there at room temperature for about three hours, and the chemisorptive molecules were chemisorbed to the surface of the glass substrate (monomolecular layer formation step). After the monomolecular layer formation step, the glass substrate was immersed in a chloroform solution to wash off unreacted film material molecules that have remained. Thus, a monomolecular film is formed without defects on its surface.

Since there are numerous hydroxyl groups including active hydrogen at the surface of the glass substrate, a monomolecular film constituted by the chemisorptive molecules shown in Chemical Formula (R) is formed by chemical bonding with covalent bonds due to a dechlorination reaction between these hydroxyl groups and the -SiCl bond groups of the chemisorptive molecules. It should be noted that Chemical Formula (R) shows the case that all of the -SiCl bond groups in the chemisorptive molecules have reacted with the surface of the glass substrate, but it is sufficient if at least one of the -SiCl bond groups reacts with the surface of the glass substrate.

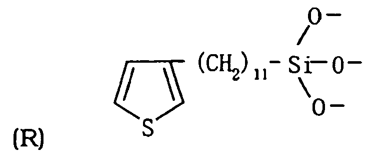

Next, the surface of the formed monomolecular film is subjected to a rubbing process using a rubbing device (Fig. 5A) as used for the production of liquid crystal orientation films, and the chemisorptive molecules constituting the monomolecular film are oriented (tilt processing step). In the rubbing process, rubbing was carried out using a rubbing roll of 7.0 cm diameter around which a rubbing cloth made of rayon is wrapped and at the conditions of an indentation depth of 0.3 mm, a nip width of 11.7 mm, a rotation speed of 1200 rotations/sec, and a table speed (substrate feed-forward speed) of 40 mm/sec. Thus, a monomolecular film was oriented (tilted) substantially parallel to the rubbing direction.

Next, using vapor deposition, photolithography and etching, a pair of platinum electrodes of 50 mm length were deposited on the surface of the monomolecular film at a spacing of 5 mm, the substrate was immersed in super-pure water at room temperature, and a voltage of 8 V was applied for six hours between the pair of platinum electrodes, thus performing polymerization through electrolytic oxidation (conductive region formation step). Thus, with Chemical Formula (S) below serving as the polymerization units, a conductive region having a conductive network including conductive polythienyl conjugated systems linked in a predetermined direction (rubbing direction) could be formed between the pair of platinum electrodes (conductive region formation step).

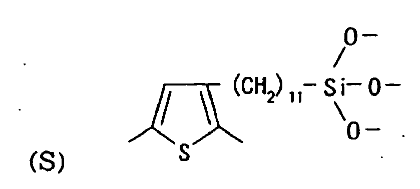

The film thickness of the resulting organic conductive film was about 2.0 nm, and the thickness of the polythienylene portion was about 0.2 nm.

A current of 1 mA could be caused to flow between the pair of platinum electrodes at a voltage application of 8 V through the organic conductive film. Consequently, a monomolecular film having a conductive region in which the conductance of the conductive network is about 10³S/cm was obtained even without doping with impurities such as donors and acceptors.

### Working Example 8 - not according to the present invention but allowing a better understanding of the present invention

This working example is about a monomolecular film having a conductive region including a conductive network formed by catalytic polymerization.

First, a chemisorptive solution was prepared by diluting the chemisorptive molecules shown in Chemical Formula (T) including acetylene groups (-C≡C-), which are conjugated polymerizable functional groups, and trichlorosilyl groups (-SiCl₃) at the molecule ends, which react with active hydrogen, to 1% in an organic solvent of dehydrated dimethylsilicone. Furthermore, an insulating silica film was prepared on the surface of an insulating polyimide substrate and the surface of the silica film was subjected to a rubbing process (preprocessing step), thus forming a rubbed polyimide substrate.

### (T) (CH₃)₃Si-C≡C-(CH₂)₁₀-SiCl₃

Next, the rubbed polyimide substrate was immersed in the chemisorptive solution to chemisorb the chemisorptive molecules to the substrate of the silica film (monomolecular layer formation step). After the monomolecular layer formation step, the rubbed polyimide substrate was immersed in a chloroform solution to wash off unreacted film material molecules remaining on the polyimide substrate. Thus, a monomolecular film as shown in Chemical Formula (U) below was formed without defects on its surface.

### (U) (CH₃)₃Si-C≡C-(CH₂)₁₀-Si(-O-)₃

It should be noted that since a rubbed polyimide substrate was used, the chemisorptive molecules constituting the monomolecular film were oriented in the rubbing direction.

Next, the polyimide substrate on which the monomolecular film had been formed was immersed in a toluene solvent including a Ziegler-Natta catalyst (5 × 10⁻² mol triethylaluminum per liter solution and 2.5 × 10⁻² mol of tetrabutyltitanate per liter solution), and a catalytic polymerization was performed (conductive region formation step). Thus, a conductive region was formed having a conductive network including polyacetylene-type conjugated systems as shown in the Chemical Formula (V) below, linked in the rubbing direction.

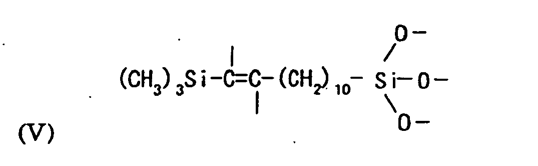

Next, the conductive region was doped with iodine ions serving as a substance with carrier mobility. Thus, a conductive region with a conductance of about 10⁴S/cm could be formed. It should be noted that when doping was not performed, then the conductance of the conductive region having a conductive network including polyacetylene-type conjugated systems was not high enough to be used as a conductor for a cable or wiring.

### Working Example 9 - not according to the present invention but allowing a better understanding of the present invention

This working example is about a monomolecular film having a conductive region including a conductive network formed by polymerization through irradiation with an energy beam.

First, a chemisorptive solution was prepared by diluting the chemisorptive molecules to be used as the film material molecules, shown in below Chemical Formula (W) including diacetylene groups (-C≡C-C≡C-), which are conjugated polymerizable functional groups, and trichlorosilyl groups (-SiCl₃) at the molecule ends, which react with active hydrogen, to 1% in an organic solvent of dehydrated dimethylsilicone.

### (W) (CH₃)₃Si-C≡C-C≡C-(CH₂)₁₀-SiCl₃

A monomolecular film was prepared in the same manner as in Working Example 8, except that the chemisorptive agent including diacetylene was used (monomolecular layer formation step). Next, after subjecting the surface of the monomolecular film to a rubbing process (tilt processing step), UV light serving as an energy beam was irradiated onto the entire surface at an energy density of 100 mJ/cm², thus performing polymerization by energy irradiation (conductive region formation step). Thus, a conductive region having a conductive network could be formed including polyacetylene-type conjugated systems as shown in the below Chemical Formula (X) linked in the rubbing direction

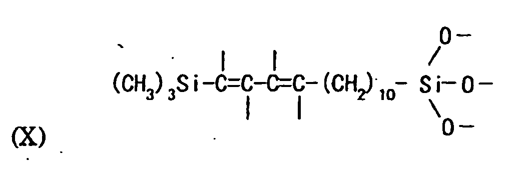

Furthermore, in this Working Example, organic molecules including diacetylene groups were used for the film material molecules C, but a monomolecular film having a conductive region of substantially the same conductivity was also obtained when using molecules including acetylene groups (-C≡C-) as shown in Chemical Formula 8 for the film material molecules, and irradiating an electron beam at 100 mJ/cm² in an inert gas atmosphere.

### Working Example 10 - not according to the present invention but allowing a better understanding of the present invention

This working example is about a monomolecular film having a conducting region, in which catalytic polymerization and energy beam irradiation polymerization are used, and a conductive network is formed by a two-stage polymerization reaction.

Using organic molecules having a diacetylene group as in Working Example 9, a monomolecular film was formed that had a conductive region with a conductive network including polydiacetylene conjugated systems. Polymerization by energy beam irradiation was performed by irradiating this monomolecular film with X-rays serving as energy beams, thus forming a conductive region having a conductive network including polyacene conjugated systems.

### Working Example 11 - not according to the present invention but allowing a better understanding of the present invention

This working example is about a monomolecular built-up film having a conducting region including a conductive network formed by polymerization through energy beam irradiation.

After forming a first monomolecular film in the same manner as in Working Example 9, a monomolecular layer formation step applying the Langmuir-Blodgett method was performed twice in succession, thus forming a monomolecular built-up film with a total of three layers. All monomolecular layers were irradiated together with an energy beam, forming a conductive network. Thus, when organic molecules having an diacetylene group were used for the film material molecules, a monomolecular built-up film having a conductive region provided with a conductive polydiacetylene network could be manufactured, and when organic molecules having an acetylene group were used for the film material molecules, a monomolecular built-up film having a conductive region provided with a conductive polyacetylene network could be manufactured.

### Working Example 12

A chemisorptive solution was prepared by diluting the compound obtained in Working Example 1 to 1% in a dehydrated dimethylsilicone solvent. A glass fiber of 1 mm diameter was immersed in this chemisorptive solution for one hour at room temperature (25°C), a dechlorination reaction took place at the surface of the glass fiber, and a thin film was formed. Next, the unreacted compound was washed off with a non-aqueous solution of chloroform. Thus, a monomolecular film was formed by causing a dehydrochlorination reaction between the hydroxyl groups at the surface of the glass fiber and the chlorosilyl groups (-SiCl) of the compound.

Next, the glass fiber provided with the monomolecular film was immersed in a chloroform solution and washed, and when lifting it from the chloroform solution, the monomolecular film was oriented in the lengthwise direction by letting the solution run off it.

Next, a nickel thin film was vapor deposited on a portion at the ends of the glass fiber.

After that, an electric field of 5 V/cm was applied between the electrodes in a pure water solution, and polymerization through electrolytic oxidation was carried out. The conditions for this polymerization through electrolytic oxidation were a reaction temperature of 25°C and a reaction time of eight hours. Thus, a conductive network was formed by electrolytic polymerization, and the two electrodes were connected electrically. In this situation, the conjugated bonds are formed by self-organization along the direction of the electric field, so that when the polymerization has been completely finished, the two electrodes are electrically connected by a conductive network. Thus, a conjugated bond polymerization film of polypyrrole of 10 mm length could be formed on the glass fiber in the axial direction of the glass fiber. The film thickness of the organic thin film was about 2.0 nm, and the thickness of the polypyrrole portion was about 0.2 nm. Furthermore, the resulting organic conductive film was transparent to visible light.

An electric cable was produced by forming an insulating film so as to cover the surface of the thusly obtained organic thin film. Fig. 8A shows a cross-sectional view of the resulting conductor. In Fig. 8A, 11 is a glass core, 6 is a polypyrrole electrolytic oxide polymer film, 13 is an insulating cover film made of silicone rubber curing at room temperature.

Using a commercial atomic force microscope (AFM) (SAP 3800N by Seiko Instruments Co., Ltd.) the conductivity p of the obtained organic conducting film without doping at room temperature (25°) was measured to be 1 × 10³ S/cm in the AFM-CITS mode and under the conditions of voltage: 1 mV and current: 160 nA.

Moreover, by doping with iodine ions, a conductivity ρ of 1 × 10⁴ S/cm could be attained.

An electric cable was produced by forming an insulating film covering the surface of the thusly obtained organic thin film. For the covering insulating film, silicone rubber curing at room temperature was used.

In this working example, the electric cable also can be formed as an aggregate conductor including a plurality of cores that are electrically insulated from one another.

Furthermore, when forming the conductor, it is also possible to use a core made of metal instead of glass. In the case of metal, the monomolecular film can be formed easily when forming an oxide on the surface.

### Working Example 13

A device (liquid crystal display device) using the conductive region of the monomolecular film described in Working Example 1 as a transparent electrode was tested.

First, a TFT substrate was prepared by forming amorphous silicon thin-film transistors (TFTs) in a matrix on a first substrate, and forming a predetermined wiring. Furthermore, a color filter substrate with a color filter formed on a second substrate was prepared.

Next, instead of the indium tin oxide (ITO) alloy film that is ordinarily formed on the surface of the color filter as a transparent electrode, a monomolecular film having on its entire surface a conductive region of at least 10² S/cm conductance was formed on a silica film disposed on the color filter surface of the color filter substrate.

Next, a first orientation film was formed on the TFT array substrate, and a second orientation film was formed on the color filter substrate. Then, an empty cell was produced by laminating the TFT array substrate and the color filter substrate together at a spacing of 5 µm with the first orientation film and the second orientation film facing inwards.

Finally, after filling a liquid crystal into the empty cell, the liquid crystal was sealed into the cell, thus producing a liquid crystal display device. Other than the fact that, instead of an ITO film, a monomolecular film was formed on the silica film formed on the color filter surface of the color filter substrate, conventional technology was used.

Using the liquid crystal display device formed as described above, an image display could be performed that is in no way inferior to the image display of conventional liquid crystal display devices using an ITO film for the transparent electrodes.

### Working Example 14

In the Working Examples 1 to 13, whether the conductive molecules are oriented can be confirmed by forming a liquid crystal cell 170 as shown in Fig. 16, placing it between polarizers 177 and 178, irradiating light from the back surface, and observing it from the position 180. In the liquid crystal cell 170, the glass plates 171 and 173 are provided with conductive molecular films 172 and 174 that face inwards, and the periphery is sealed with an adhesive 175 at a gap spacing of 5 to 6 µm. The inside of the liquid crystal cell 170 is filled with a liquid crystal composition 176 (nematic liquid crystal, for example "LC, MT-5087LA" by Chisso Corp.)
(1) The polarizers 177 and 178 are arranged perpendicular to one another, and the orientation directions of the conductive molecular films 172 and 174 are aligned, such that the orientation direction is parallel to one of the polarizers and perpendicular to the other polarizers. If they are perfectly oriented, then the liquid crystal is oriented and a uniform black is obtained. If a uniform black is not obtained, then there are deficiencies in the orientation.
(2) The polarizers 177 and 178 are arranged in parallel, and the orientation directions of the conductive molecular films 172 and 174 are aligned, such that direction is parallel to both polarization plates. If they are perfectly oriented, then the liquid crystal is oriented and a uniform white is obtained. If a uniform white is not obtained, then there are deficiencies in the orientation.

It should be noted that if the substrate on the rear side is not transparent, then it is possible to arrange one polarizer on the upper side, irradiate light from the front side and observe the reflected light.

With this method, it is possible to confirm whether the conductive molecular film obtained with Working Examples 1 to 13 is oriented.

### INDUSTRIAL APPLICABILITY

As explained in the foregoing, the present invention presents an organic thin film having a conductive region that can be utilized for conductors, wiring, electrodes or transparent electrodes. Moreover, the present invention presents high-performance devices, such as semiconductor devices, capacitors, liquid crystal display elements, electroluminescence elements and solar cells, using this organic thin film having a conductive region as conductors, wiring, electrodes or transparent electrodes. Furthermore, the present invention presents an electric cable, such as a coaxial cable or a flat cable, using this organic thin film having a conductive region.

## Claims

1. A conductive organic thin film made of organic molecules comprising a terminal bond group that is covalently bonded to a surface of a substrate material or a surface of a primer layer formed on the substrate material, a conjugated bond group, and an alkyl group between the terminal bond group and the conjugated bond group,
wherein the organic molecules are oriented, and the conjugated bond group is polymerized with the conjugated bond groups of other molecules, forming a conductive network by electrolytic polymerization carried out by contacting electrodes directly with the film,
the conductive network is linked and has a conductive anisotropy in a plane of the conductive organic thin film, and
the conductive organic thin film is a monomolecular film or a monomolecular built-up film,
wherein molecular units forming the conductive network can be expressed by the following Chemical Formula (A) or (B) 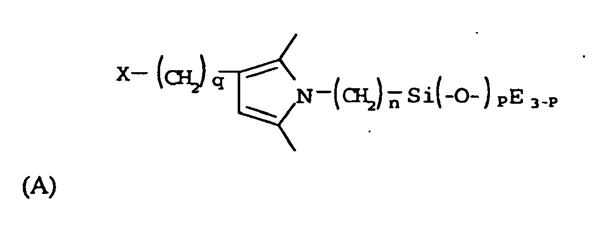 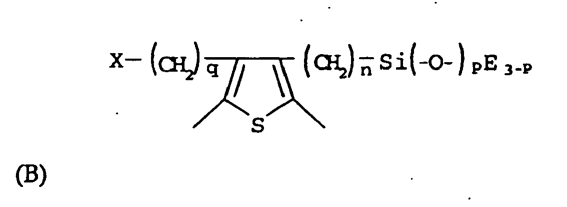 wherein X denotes hydrogen, an ester group or an organic group including an unsaturated group, q denotes an integer of 0 to 10, E denotes hydrogen or an alkyl group with a carbon number of 1 to 3, n denotes an integer of at least 2 and at most 25, and p denotes an integer of 1, 2 or 3.

2. The conductive organic thin film of claim 1, wherein the polymerization of a last stage is polymerization through electrolytic oxidation.

3. The conductive organic thin film of claim 1, wherein a conductivity (p) of the conductive organic film without dopants is at least 1 S/cm at room temperature (25° C).

4. The conductive organic thin film of claim 3, wherein the conductivity (p) of the conductive organic film without dopants is at least 1 × 10³ S/cm at room temperature (25°C).

5. The conductive organic thin film of claim 1, wherein the polymerized conjugated bond group is at least one conjugated bond group selected from polypyrrole, and polythienylene.

6. The conductive organic thin film of claim 1, wherein the terminal bond group is at least one bond selected from siloxane (-SiO-) and SiN- bonds (wherein the Si and the N can also be furnished with other bonded groups with corresponding valence.)

7. The conductive organic thin film of claim 1, wherein the orientation of the molecules is achieved by at least one selected from an orientation process by rubbing, a process of letting a reaction solution run off the substrate surface after covalently bonding the molecules to the substrate surface in an elimination reaction, a process of irradiating polarized light, and orientation by fluctuations of the molecules during polymerization.

8. The conductive organic thin film of claim 1, wherein the conductive region of the organic thin film is transparent to light of a wavelength in a visible region.

9. The conductive organic thin film of claim 1, wherein a protective film is further provided on a surface of the conductive region of the conductive organic thin film.

10. The conductive organic thin film of claim 1, wherein the conductive organic thin film further comprises a dopant substance.

11. A method of manufacturing a conductive organic thin film, comprising:
bringing a chemisorptive compound, comprising a terminal functional group that can covalently bond to a surface of a substrate material or a surface of a primer layer formed on the substrate material, a conjugated bondable functional group, and an alkyl group between the terminal functional group and the conjugated bondable functional group,
in contact with the surface of the substrate material or the surface of the primer layer formed on the substrate material, said surface having active hydrogen or being furnished with active hydrogen, and forming covalent bonds by an elimination reaction,
orienting the organic molecules constituting the organic thin film in a predetermined direction or orienting them during the polymerization step,
forming a conductive network by bonding the conjugated bondable groups to one another by conjugated bonding in the polymerization step by electrolytic polymerization carried out by contacting electrodes directly with the film,
the conductive network is linked and has a conductive anisotropy in a plane of the conductive organic thin film, and
the conductive organic thin film is a monomolecular film or a monomolecular built-up film,
wherein the organic molecules can be expressed by the following Chemical Formula (C) or (D) 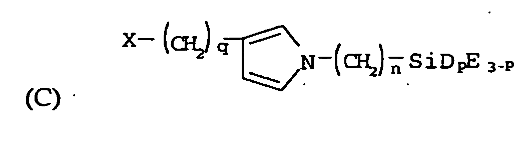 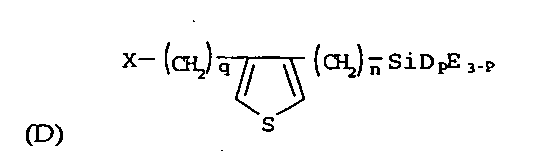 wherein X denotes hydrogen, an ester group or an organic group including an unsaturated group, q denotes an integer of 0 to 10, D denotes a halogen atom, an isocyanate group or an alkoxyl group with a carbon number of 1 to 3, E denotes hydrogen or an alkyl group with a carbon number of 1 to 3, n denotes an integer of at least 2 and at most 25, and p denotes an integer of 1, 2 or 3.

12. The method of manufacturing a conductive organic thin film according to claim 11, wherein the terminal functional group is a halogenated silyl group, an alkoxysilyl group or an isocyanate group, and covalent bonds are formed by at least one elimination reaction selected from dehydrochlorination reaction, dealcoholization reaction and deisocyanation reaction with the active hydrogen of the substrate material surface.

13. The method of manufacturing a conductive organic thin film according to claim 11, wherein the conjugated bondable group is at least one group selected from pyrrolyl groups, and thienyl groups.

14. The method of manufacturing a conductive organic thin film according to claim 11, wherein the orientation of the molecules is achieved by at least one process selected from an orientation process by rubbing, a process of letting a reaction solution run off the tilted substrate surface after covalently bonding the molecules to the substrate surface in an elimination reaction, a process of irradiating polarized light, and orientation by fluctuations of the molecules during polymerization.

15. The method of manufacturing a conductive organic thin film according to claim 11, wherein the organic molecules are formed into a monomolecular layer.

16. The method of manufacturing a conductive organic thin film according to claim 15, wherein monomolecular layers are layered one on another by repeating the monomolecular layer formation step a plurality of times, thus forming a monomolecular built-up film.

17. The method of manufacturing a conductive organic thin film according to claim 15, wherein after the monomolecular layer formation step and the tilt processing step have been repeated in alternation, the conductive network is formed collectively in the monomolecular layers of the monomolecular built-up film in the conductive network formation step, thus forming a conductive monomolecular built-up film.

18. The method of manufacturing a conductive organic thin film according to claim 11, wherein a conductive monomolecular built-up film is formed by repeating the monomolecular layer formation step, the tilt processing step and the conductive network formation step.

19. The method of manufacturing a conductive organic thin film according to claim 11, wherein the polymerization is polymerization through electrolytic oxidation.

20. The method of manufacturing a conductive organic thin film according to claim 11, wherein dopants are added during or after the conductive network formation.

21. An electrode formed with a conductive organic thin film that is transparent at an optical wavelength in a visible optical region,
wherein the conductive organic thin film is made of organic molecules comprising a terminal bond group that is covalently bonded to a surface of a substrate material or a surface of a primer layer formed on the substrate material, a conjugated bond group, and an alkyl group between the terminal bond group and the conjugated bond group,
wherein the organic molecules are oriented, and the conjugated bond group is polymerized with the conjugated bond groups of other molecules, thus forming a conductive network product by electrolytic polymerization carried out by contacting electrodes directly with the film,
the conductive network is linked and has a conductive anisotropy in a plane of the conductive organic thin film, and
the conductive organic thin film is a monomolecular film or a monomolecular built-up film,
wherein molecular units forming the conductive network can be expressed by the following Chemical Formula (A) or (B) 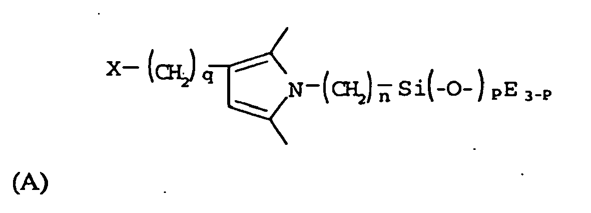 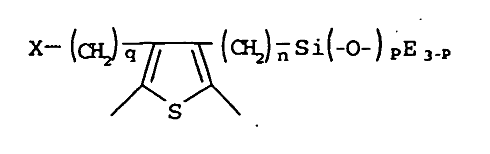 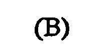 wherein X denotes hydrogen, an ester group or an organic group including an unsaturated group, q denotes an integer of 0 to 10, E denotes hydrogen or an alkyl group with a carbon number of 1 to 3, n denotes an integer of at least 2 and at most 25, and p denotes an integer of 1, 2 or 3.

22. An electric cable comprising a core and a conductive organic thin film formed in a longitudinal direction on a surface of the core;
wherein the conductive organic thin film is made of organic molecules comprising a terminal bond group that is covalently bonded to a surface of a substrate material or a surface of a primer layer formed on the substrate material, a conjugated bond group, and an alkyl group between the terminal bond group and the conjugated bond group,
wherein the organic molecules are oriented, and the conjugated bond group is polymerized with the conjugated bond groups of other molecules, forming a conductive network product by electrolytic polymerization carried out by contacting electrodes directly with the film,
the conductive network is linked and has a conductive anisotropy in a plane of the conductive organic thin film, and
the conductive organic thin film is a monomolecular film or a monomolecular built-up film,
wherein molecular units forming the conductive network can be expressed by the following Chemical Formula (A) or (B) 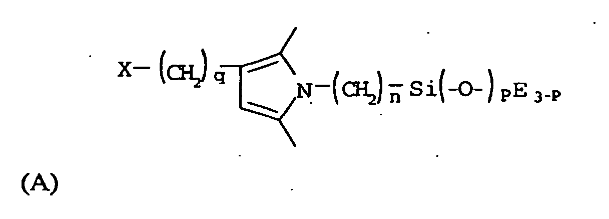 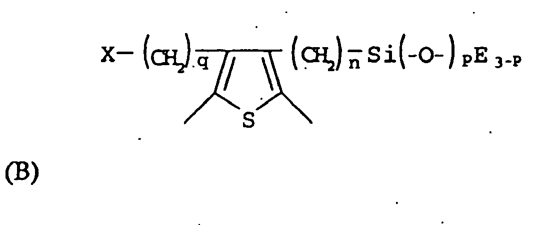 wherein X denotes hydrogen, an ester group or an organic group including an unsaturated group, q denotes an integer of 0 to 10, E denotes hydrogen or an alkyl group with a carbon number of 1 to 3, n denotes an integer of at least 2 and at most 25, and p denotes an integer of 1, 2 or 3.

23. The electric cable according to claim 22, wherein the electric cable is formed as an aggregate conductor including a plurality of cores that are electrically insulated from one another.

24. The electric cable according to claim 22, wherein the core is made of glass or of metal.

## Patentansprüche

1. Leitfähiger organischer dünner Film, hergestellt aus organischen Molekülen, die eine terminale Bindungs-Gruppe, die kovalent an eine Oberfläche eines Substrat-Materials oder eine Oberfläche einer Primer-Schicht, die auf dem Substrat-Material gebildet ist, gebunden ist, eine konjugierte Bindungs-Gruppe und eine Alkyl-Gruppe zwischen der terminalen Bindungs-Gruppe und der konjugierten Bindungs-Gruppe umfassen, worin die organischen Moleküle orientiert sind und die konjugierte Bindungs-Gruppe mit den konjugierten Bindungs-Gruppen anderer Moleküle polymerisiert ist und so ein leitfähiges Netzwerk durch elektrolytische Polymerisation bildet, die durchgeführt wird durch In-Kontakt-Bringen von Elektroden direkt mit dem Film,
das leitfähige Netzwerk verknüpft ist und eine leitfähige Anisotropie in einer Ebene des leitfähigen organischen dünnen Films aufweist und der leitfähige organische dünne Film ein monomolekularer Film oder ein monomolekularer Aufbau-Film ist,
worin Molekül-Einheiten, die das leitfähige Netzwerk bilden, ausgedrückt werden können durch die folgenden chemischen Formeln (A) oder (B): 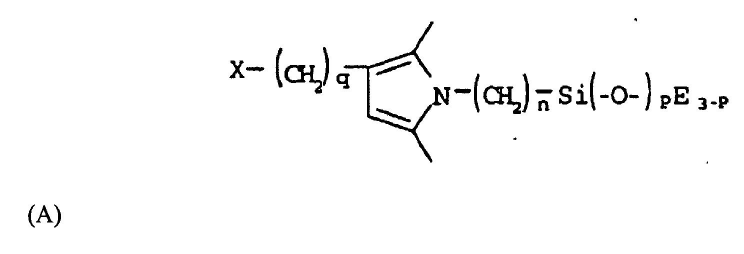 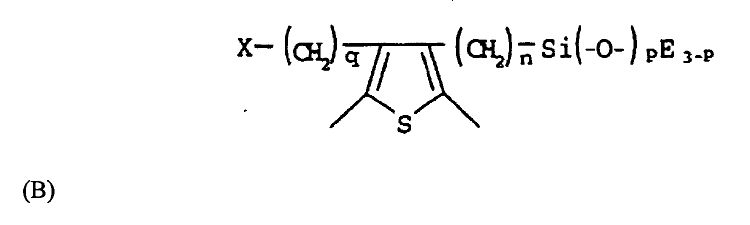 worin X steht für Wasserstoff, eine Ester-Gruppe oder eine organische Gruppe, die eine ungesättigte Gruppe einschließt; q für eine ganze Zahl von 0 bis 10 steht; E für Wasserstoff oder eine Alkyl-Gruppe mit einer Kohlenstoff-Zahl von 1 bis 3 steht; n für eine ganze Zahl von wenigstens 2 und höchstens 25 steht; und p für eine ganze Zahl von 1, 2, oder 3 steht.

2. Leitfähiger organischer dünner Film nach Anspruch 1, worin die Polymerisation einer letzten Stufe eine Polymerisation durch elektrolytische Oxidation ist.

3. Leitfähiger organsicher dünner Film nach Anspruch 1, worin die Leitfähigkeit (p) des leitfähigen organischen Films ohne Dotierungsmittel wenigstens 1 S/cm bei Raumtemperatur (25° C) ist.

4. Leitfähiger organischer dünner Film nach Anspruch 3, worin die Leitfähigkeit (p) des leitfähigen organischen Films ohne Dotierungsmittel wenigstens 1 x 10³ S/cm bei Raumtemperatur (25° C) ist.

5. Leitfähiger organischer dünner Film nach Anspruch 1, worin die polymerisierte konjugierte Bindungs-Gruppe wenigstens eine konjugierte Bindungs-Gruppe ist, die gewählt ist aus Polypyrrol und Polythienylen.

6. Leitfähiger organischer dünner Film nach Anspruch 1, worin die terminale Bindungs-Gruppe wenigstens eine Bindung ist, die gewählt ist aus Siloxan- (-SiO-) und -SiN-Bindungen (worin das Si-Atom und das N-Atom auch mit anderen gebundenen Gruppen mit entsprechender Valenz versehen sein können).

7. Leitfähiger organischer dünner Film nach Anspruch 1, worin die Orientierung der Moleküle erreicht wird durch wenigstens einen Prozess, der gewählt ist aus einem Orientierungs-Prozess durch Reiben, einem Prozess des Herablaufen-Lassens einer Reaktions-Lösung von der Substrat-Oberfläche nach kovalentem Binden der Moleküle an der Substrat-Oberfläche in einer Eliminierungs-Reaktion, einem Prozess des Bestrahlens mit polarisiertem Licht und einer Orientierung durch Fluktuationen der Moleküle während der Polymerisation.

8. Leitfähiger organischer dünner Film nach Anspruch 1, worin der leitfähige Bereich des organischen dünnen Films transparent für Licht einer Wellenlänge im sichtbaren Bereich ist.

9. Leitfähiger organischer dünner Film nach Anspruch 1, worin ein Schutzfilm weiter auf einer Oberfläche des leitfähigen Bereichs des leitfähigen organischen dünnen Films vorgesehen ist.

10. Leitfähiger organischer dünner Film nach Anspruch 1, worin der leitfähige organische dünne Film weiter eine dotierende Substanz umfasst.

11. Verfahren zur Herstellung eines leitfähigen organischen dünnen Films, umfassend die Schritte, dass man
- eine chemisorptive Verbindung, die eine terminale funktionelle Gruppe, die sich kovalent an eine Oberfläche eines Substrat-Materials oder eine Oberfläche einer Primer-Schicht, die auf dem Substrat-Material gebildet ist, binden kann, eine konjugierte bindungsfähige funktionelle Gruppe und eine Alkyl-Gruppe zwischen der terminalen funktionellen Gruppe und der konjugierten bindungsfähigen funktionellen Gruppe umfasst, in Kontakt mit der Oberfläche des Substrat-Materials oder der Oberfläche der Primer-Schicht, die auf dem Substrat-Material gebildet ist, bringt, wobei die Oberfläche aktiven Wasserstoff aufweist oder mit aktivem Wasserstoff versehen ist, und kovalente Bindungen durch eine Eliminierungs-Reaktion ausbildet;
- die organischen Moleküle, aus denen der organische dünne Film besteht, in einer vorbestimmten Richtung orientiert oder sie während des Polymerisations-Schritts orientiert;
- ein leitfähiges Netzwerk bildet durch Binden der konjugierten bindungsfähigen Gruppen aneinander durch konjugiertes Binden in dem Polymerisations-Schritt durch elektrolytische Polymerisation, die durch direktes In-Kontakt-Bringen der Elektroden mit dem Film durchgeführt wird;
- das leitfähige Netzwerk verknüpft ist und leitfähige Anisotropien in einer Ebene des leitfähigen organischen dünnen Films aufweist; und
- der leitfähige organische dünne Film ein monomolekularer Film oder ein monomolekularer Aufbau-Film ist,
- worin die organischen Moleküle ausgedruckt werden können durch die folgende chemische Formel (C) oder (D) 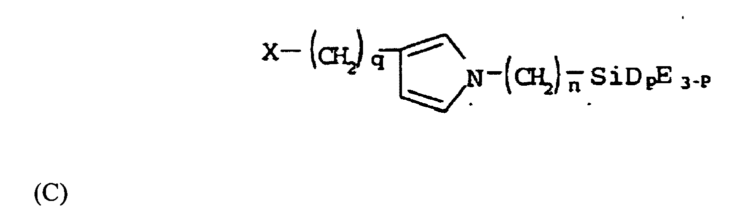 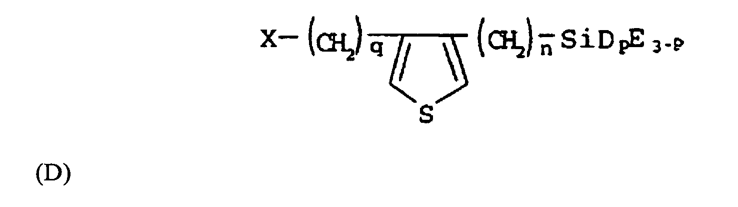
worin X steht für Wasserstoff, eine Ester-Gruppe oder eine organische Gruppe, die eine ungesättigte Gruppe einschließt; q für eine ganze Zahl von 0 bis 10 steht; D für ein Halogen-Atom, eine Isocyanat-Gruppe oder eine Alkoxy-Gruppe mit einer Kohlenstoff-Zahl von 1 bis 3 steht; E für Wasserstoff oder eine Alkyl-Gruppe mit einer Kohlenstoff-Zahl von 1 bis 3 steht; n für eine ganze Zahl von wenigstens 2 und höchstens 25 steht; und p für eine ganze Zahl von 1, 2, oder 3 steht.

12. Verfahren zur Herstellung eines leitfähigen organischen dünnen Films nach Anspruch 11, worin die terminale funktionelle Gruppe eine halogenierte Silyl-Gruppe, eine Alkoxy-Silyl-Gruppe oder eine Isocyanat-Gruppe ist und kovalente Bindungen gebildet werden durch wenigstens eine Eliminierungs-Reaktion, die gewählt ist aus Dehydrochlorierungs-Reaktion, Dealkoholisierungs-Reaktion und Deisocyanatisierungs-Reaktion mit dem aktiven Wasserstoff der Substrat-Material-Oberfläche.

13. Verfahren zur Herstellung eines leitfähigen organischen dünnen Films nach Anspruch 11, worin die konjugierte, zur Bindung befähigte Gruppe wenigstens eine Gruppe ist, die gewählt ist aus Pyrrolyl-Gruppen und Thienyl-Gruppen.

14. Verfahren zur Herstellung eines leitfähigen organischen dünnen Films nach Anspruch 11, worin die Orientierung der Moleküle erreicht wird durch wenigstens einen Prozess, der gewählt ist aus einem Orientierungs-Prozess durch Reiben, einen Prozess des Herablaufen-Lassens der Reaktions-Lösung entlang der gekippten Substrat-Oberfläche nach kovalentem Binden der Moleküle an die Substrat-Oberfläche in einer Eliminierungs-Reaktion, einen Prozess des Bestrahlens mit polarisiertem Licht und einer Orientierung durch Fluktuationen der Moleküle während der Polymerisation.

15. Verfahren zur Herstellung eines leitfähigen organischen dünnen Films nach Anspruch 11, worin die organischen Moleküle zu einer monomolekularen Schicht gebildet werden.

16. Verfahren zur Herstellung eines leitfähigen organischen dünnen Films nach Anspruch 15, worin die monomolekularen Schichten aufeinander geschichtet werden durch Wiederholen des Schritts des Bildens einer monomolekularen Schicht für eine Mehrzahl von Malen, wodurch ein monomolekularer Aufbau-Film gebildet wird.

17. Verfahren zur Herstellung eines leitfähigen organischen dünnen Films nach Anspruch 15, worin nach dem Zeitpunkt, zu dem der Schritt der Bildung der monomolekularen Schicht und der Kipp-Verarbeitungs-Schritt mehrfach wechselnd wiederholt wurden, das leitfähige Netzwerk gemeinsam in den monomolekularen Schichten des monomolekularen Aufbau-Films in dem Schritt der Bildung des leitfähigen Netzwerks gebildet werden und so ein leitfähiger monomolekularer Aufbau-Film gebildet wird.

18. Verfahren zur Herstellung eines leitfähigen organischen dünnen Films nach Anspruch 11, worin ein leitfähiger monomolekularer Aufbau-Film gebildet wird durch Wiederholen des Schritts der Bildung einer monomolekularen Schicht, des Schritts der Kipp-Verarbeitung und des Schritts der Bildung des leitfähigen Netzwerks.

19. Verfahren zur Herstellung eines leitfähigen organischen dünnen Films nach Anspruch 11, worin die Polymerisation eine Polymerisation durch elektrolytische Oxidation ist.

20. Verfahren zur Herstellung eines leitfähigen organischen dünnen Films nach Anspruch 11, worin Dotierungsmittel während oder nach der Bildung des leitfähigen Netzwerks zugesetzt werden.

21. Elektrode, gebildet mit einem leitfähigen organischen dünnen Film, der transparent bei einer optischen Wellenlänge im sichtbaren optischen Bereich ist,
worin der leitfähige organische dünne Film hergestellt ist aus organischen Molekülen, die eine terminale Bindungs-Gruppe, die kovalent an eine Oberfläche eines Substrat-Materials oder eine Oberfläche einer Primer-Schicht, die auf dem Substrat-Material gebildet ist, gebunden ist, eine konjugierte Bindungs-Gruppe und eine Alkyl-Gruppe zwischen der terminalen Bindungs-Gruppe und der konjugierten Bindungs-Gruppe umfassen,
worin die organischen Moleküle orientiert sind und die konjugierte Bindungs-Gruppe mit den konjugierten Bindungs-Gruppen anderer Moleküle polymerisiert ist, wodurch ein leitfähiges Netzwerk-Produkt durch elektrolytische Polymerisation gebildet wird, die durchgeführt wird durch In-Kontakt-Bringen von Elektroden direkt mit dem Film,
das leitfähige Netzwerk verknüpft ist und eine leitfähige Anisotropie in einer Ebene des leitfähigen organischen dünnen Films aufweist; und
der leitfähige organische dünne Film ein monomolekularer Film oder ein monomolekularer Aufbau-Film ist;
worin Molekül-Einheiten, die das leitfähige Netzwerk bilden, ausgedrückt werden können durch die folgenden chemischen Formeln (A) oder (B): 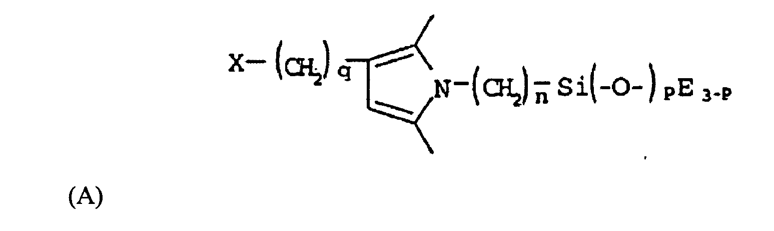 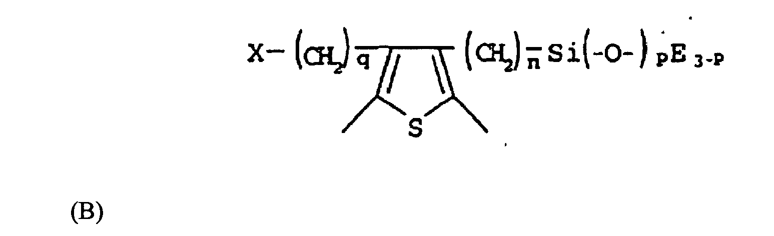 worin X steht für Wasserstoff, eine Ester-Gruppe oder eine organische Gruppe, die eine ungesättigte Gruppe einschließt; q für eine ganze Zahl von 0 bis 10 steht; E für Wasserstoff oder eine Alkyl-Gruppe mit einer Kohlenstoff-Zahl von 1 bis 3 steht; n für eine ganze Zahl von wenigstens 2 und höchstens 25 steht; und p für eine ganze Zahl von 1, 2, oder 3 steht.

22. Elektrisches Kabel, umfassend einen Kern und einen leitfähigen organischen dünnen Film, der in einer Längsrichtung auf einer Oberfläche des Kerns gebildet ist, worin der leitfähige organische dünne Film hergestellt ist aus organischen Molekülen, die eine terminale Bindungs-Gruppe, die kovalent an eine Oberfläche eines Substrat-Materials oder eine Oberfläche einer Primer-Schicht, die auf dem Substrat-Material gebildet ist, gebunden ist, eine konjugierte Bindungs-Gruppe und eine Alkyl-Gruppe zwischen der terminalen Bindungs-Gruppe und der konjugierten Bindungs-Gruppe umfassen,
worin die organischen Moleküle orientiert sind und die konjugierte Bindungs-Gruppe mit den konjugierten Bindungs-Gruppen anderer Moleküle polymerisiert ist, wodurch ein leitfähiges Netzwerk-Produkt durch elektrolytische Polymerisation gebildet wird, die durchgeführt wird durch In-Kontakt-Bringen von Elektroden direkt mit dem Film,
das leitfähige Netzwerk verknüpft ist und eine leitfähige Anisotropie in einer Ebene des leitfähigen organischen dünnen Films aufweist; und
der leitfähige organische dünne Film ein monomolekularer Film oder ein monomolekularer Aufbau-Film ist;
worin Molekül-Einheiten, die das leitfähige Netzwerk bilden, ausgedrückt werden können durch die folgenden chemischen Formeln (A) oder (B): 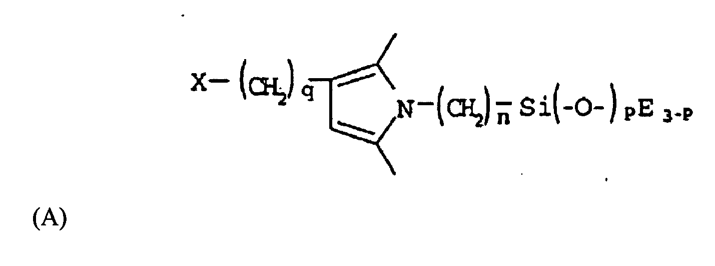 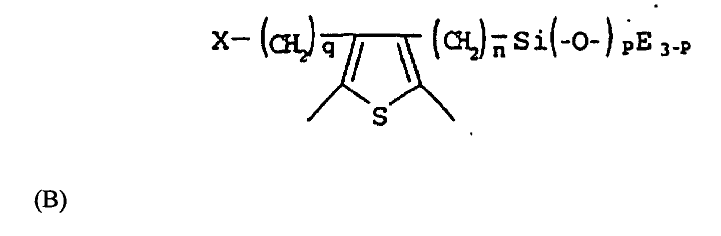 worin X steht für Wasserstoff, eine Ester-Gruppe oder eine organische Gruppe, die eine ungesättigte Gruppe einschließt; q für eine ganze Zahl von 0 bis 10 steht; E für Wasserstoff oder eine Alkyl-Gruppe mit einer Kohlenstoff-Zahl von 1 bis 3 steht; n für eine ganze Zahl von wenigstens 2 und höchstens 25 steht; und p für eine ganze Zahl von 1, 2, oder 3 steht.

23. Elektrisches Kabel nach Anspruch 22, worin das elektrische Kabel gebildet ist als ein Aggregat-Leiter, der eine Mehrzahl von Kernen einschließt, die elektrisch einander gegenüber isoliert sind.

24. Elektrisches Kabel nach Anspruch 22, worin der Kern aus Glas oder Metall hergestellt ist.

## Revendications

1. Film fin conducteur organique constitué de molécules organiques comprenant un groupe à liaison terminale qui est lié de manière covalente à une surface d'un matériau formant substrat ou à une surface d'une couche d'apprêt formée sur le matériau formant substrat, un groupe à liaison conjuguée, et un groupe alkyle entre le groupe à liaison terminale et le groupe à liaison conjuguée,
dans lequel les molécules organiques sont orientées, et le groupe à liaison conjuguée est polymérisé avec les groupes à liaison conjuguée des autres molécules, formant un réseau conducteur par polymérisation électrolytique conduite par mise en contact des électrodes directement avec le film,
le réseau conducteur est lié et possède une anisotropie conductrice dans un plan du film fin organique conducteur, et
le film fin conducteur organique est un film monomoléculaire ou un film monomoléculaire encastré,
dans lequel les motifs moléculaires formant le réseau conducteur peuvent être exprimés par la formule chimique suivante (A) ou (B) 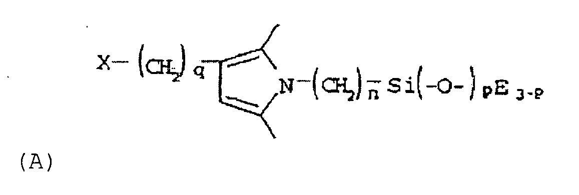 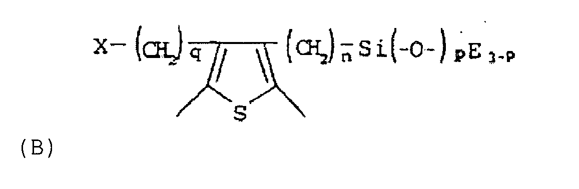 dans lesquelles X indique un atome d'hydrogène, un groupe ester ou un groupe organique incluant un groupe insaturé, q indique un nombre entier de 0 à 10, E indique un atome d'hydrogène ou un groupe alkyle avec un nombre d'atomes de carbone de 1 à 3, n indique un nombre entier d'au moins 2 et d'au plus 25, et p indique un nombre entier de 1, 2 ou 3.

2. Film fin conducteur organique selon la revendication 1, dans lequel la polymérisation au dernier stade est une polymérisation par oxydation électrolytique.

3. Film fin conducteur organique selon la revendication 1, dans lequel une conductivité (p) du film organique conducteur sans dopants est d'au moins 1 S/cm à la température ambiante (25°C).

4. Film fin conducteur organique selon la revendication 3, dans lequel la conductivité (p) du film conducteur organique sans dopants est d'au moins 1 x 10³ S/cm à la température ambiante (25°C).

5. Film fin conducteur organique selon la revendication 1, dans lequel le groupe à liaison conjuguée polymérisé est au moins un groupe à liaison conjuguée choisi parmi le polypyrrole, et le polythiénylène.

6. Film fin conducteur organique selon la revendication 1, dans lequel le groupe à liaison terminale est au moins une liaison choisie parmi les liaisons siloxane(-SiO-) et SiN- (dans lesquelles Si et N peuvent également être fournis avec d'autres groupes liés avec la valence correspondante.)

7. Film fin conducteur organique selon la revendication 1, dans lequel l'orientation des molécules est atteinte par au moins l'un choisi parmi un procédé d'orientation par frottement, un procédé laissant une solution réactionnelle ruisseler de la surface du substrat après liaison covalente des molécules à la surface du substrat dans une réaction d'élimination, un procédé d'irradiation de lumière polarisée, et l'orientation par les fluctuations des molécules durant la polymérisation.

8. Film fin conducteur organique selon la revendication 1, dans lequel la région conductrice du film fin organique est transparente à la lumière d'une longueur d'onde dans une région visible.

9. Film fin conducteur organique selon la revendication 1, dans lequel un film protecteur est en outre proposé sur une surface de la région conductrice du film fin conducteur organique.

10. Film fin conducteur organique selon la revendication 1, dans lequel le film fin conducteur organique comprend en outre une substance dopante.

11. Procédé de fabrication d'un film fin conducteur organique comprenant :
porter un composé de désorption chimique, comprenant un groupe fonctionnel terminal qui peut se lier de manière covalente à une surface d'un matériau formant substrat ou à une surface d'une couche d'apprêt formé(e) sur le matériau formant substrat, un groupe fonctionnel conjugué pouvant être lié, et un groupe alkyle entre le groupe fonctionnel terminal et le groupe fonctionnel conjugué pouvant être lié,
au contact de la surface du matériau formant substrat ou de la surface de la couche d'apprêt formée sur le matériau formant substrat, ladite surface ayant de l'hydrogène actif ou étant fournie avec de l'hydrogène actif, et formant des liaisons covalentes par une réaction d'élimination,
l'orientation des molécules organiques constituant le film fin organique dans un sens prédéterminé ou leur orientation durant l'étape de polymérisation,
la formation d'un réseau conducteur par liaison des groupes conjugués pouvant être liés l'un à l'autre par liaison conjuguée dans l'étape de polymérisation par polymérisation électrolytique conduite par mise en contact des électrodes directement avec le film,
le réseau conducteur est lié et possède une anisotropie conductrice dans un plan du film fin conducteur organique, et
le film fin conducteur organique est un film monomoléculaire ou un film monomoléculaire encastré,
dans lequel les molécules organiques peuvent être exprimées par la formule chimique suivante (C) ou (D) 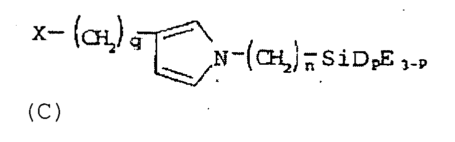 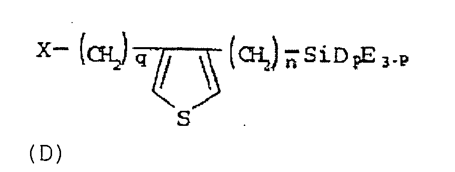 dans lesquelles X indique un atome d'hydrogène, un groupe ester ou un groupe organique incluant un groupe insaturé, q indique un nombre entier de 0 à 10, D indique un atome d'halogène, un groupe isocyanate ou un groupe alcoxyle avec un atome de carbone de 1 à 3, E indique de l'hydrogène ou un groupe alkyle avec un nombre de carbone de 1 à 3, n indique un nombre entier d'au moins 2 et d'au plus 25, et p indique un nombre entier de 1, 2 ou 3.

12. Procédé de fabrication d'un film fin conducteur organique selon la revendication 11, dans lequel le groupe fonctionnel terminal est un groupe silyle halogéné un groupe alcoxysilyle ou un groupe isocyanate, et des liaisons covalentes sont formées par au moins une réaction d'élimination choisie parmi la réaction de déshydrochloration, réaction de désalcoolisation et réaction de déisocyanuration avec l'hydrogène actif de la surface du matériau formant substrat.

13. Procédé de fabrication d'un film fin conducteur organique selon la revendication 11, dans lequel le groupe conjugué pouvant être lié est au moins un groupe choisi parmi les groupes pyrrolyle, et les groupes thiényle.

14. Procédé de fabrication d'un film fin conducteur organique selon la revendication 11, dans lequel l'orientation des molécules est atteinte par au moins un procédé choisi parmi un procédé d'orientation par frottement, un procédé laissant une solution réactionnelle ruisseler de la surface du substrat inclinée après la liaison covalente des molécules à la surface du substrat dans une réaction d'élimination, un procédé d'irradiation de lumière polarisée, et d'orientation par les fluctuations des molécules durant la polymérisation.

15. Procédé de fabrication d'un film fin conducteur organique selon la revendication 11, dans lequel les molécules organiques sont formées en une couche monomoléculaire.

16. Procédé de fabrication d'un film fin conducteur organique selon la revendication 15, dans lequel les couches monomoléculaires sont stratifiées l'une sur l'autre en répétant l'étape de formation de couche monomoléculaire une pluralité de fois, formant ainsi un film monomoléculaire encastré.

17. Procédé de fabrication d'un film fin conducteur organique selon la revendication 15, dans lequel après que l'étape de formation de la couche monomoléculaire et l'étape de transformation de l'inclinaison aient été répétées en alternance, le réseau conducteur soit formé dans son ensemble dans les couches monomoléculaires du film monomoléculaire encastré dans l'étape de formation du réseau conducteur, formant ainsi un film monomoléculaire conducteur encastré.

18. Procédé de fabrication d'un film fin conducteur organique selon la revendication 11, dans lequel un film monomoléculaire conducteur encastré est formé en répétant l'étape de formation de la couche monomoléculaire, l'étape de transformation de l'inclinaison et l'étape de formation du réseau conducteur.

19. Procédé de fabrication d'un film fin conducteur organique selon la revendication 11, dans lequel la polymérisation est la polymérisation à travers l'oxydation électrolytique.

20. Procédé de fabrication d'un film fin conducteur organique selon la revendication 11, dans lequel les dopants sont ajoutés durant ou après la formation du réseau conducteur.

21. Electrode formée avec un film fin conducteur organique qui est transparent à une longueur d'onde optique située dans une région optique visible,
dans laquelle le film fin conducteur organique est constitué de molécules organiques comprenant un groupe à liaison terminale qui est lié de manière covalente à une surface d'un matériau formant substrat ou une surface d'une couche d'apprêt formée sur le matériau formant substrat, un groupe à liaison conjuguée, et un groupe alkyle entre le groupe à liaison terminale et le groupe à liaison conjuguée,
dans laquelle les molécules organiques sont orientées, et le groupe à liaison conjuguée est polymérisé avec les groupes à liaison conjuguée des autres molécules, formant ainsi un réseau conducteur produit par polymérisation électrolytique conduite par la mise en contact des électrodes directement avec le film,
le réseau conducteur est lié et a une anisotropie conductrice dans un plan du film fin conducteur organique, et
le film fin conducteur organique est un film monomoléculaire ou un film monomoléculaire encastré,
dans laquelle les motifs moléculaires formant le réseau conducteur peuvent être exprimés par la formule chimique suivante (A) ou (B) 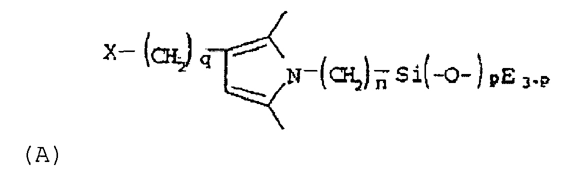 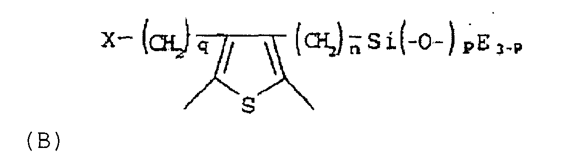 dans lesquelles X indique un atome d'hydrogène, un groupe ester ou un groupe inorganique incluant un groupe insaturé, q indique un nombre entier de 0 à 10, E indique un atome d'hydrogène ou un groupe alkyle avec un nombre d'atomes de carbone de 1 à 3, n indique nombre entier d'au moins 2 et d'au plus 25, et p indique un nombre entier de 1, 2 ou 3.

22. Câble électrique comprenant une âme et un film fin conducteur organique formé dans un sens longitudinal sur une surface de l'âme,
dans lequel le film fin conducteur organique est constitué de molécules organiques comprenant un groupe à liaison terminale qui est lié de manière covalente à une surface d'un matériau formant substrat ou à une surface d'une couche d'apprêt formée sur le matériau formant substrat, un groupe à liaison conjuguée, et un groupe alkyle entre le groupe à liaison terminale et le groupe à liaison conjuguée,
dans lequel les molécules organiques sont orientées, et le groupe à liaison conjuguée est polymérisé avec les groupes à liaison conjuguée des autres molécules, formant un réseau conducteur produit par polymérisation électrolytique conduite par la mise en contact des électrodes directement avec le film,
le réseau conducteur est lié et possède une anisotropie conductrice dans un plan du film fin conducteur organique, et
le film fin conducteur organique est un film monomoléculaire ou un film monomoléculaire encastré,
dans lequel les motifs moléculaires formant le réseau conducteur peuvent être exprimés par la formule chimique suivante (A) ou (B) 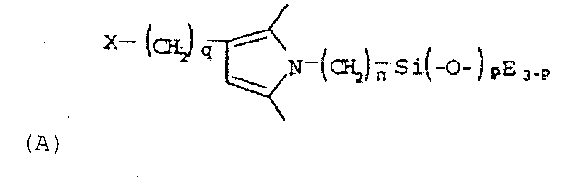 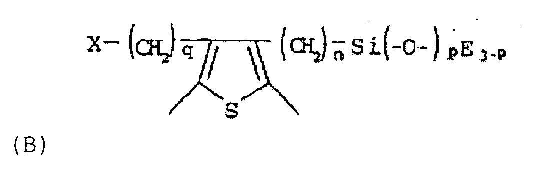 dans lesquelles X indique un atome d'hydrogène, un groupe ester ou un groupe organique incluant un groupe insaturé, q indique un nombre entier de 0 à 10, E indique un atome d'hydrogène ou un groupe alkyle avec un nombre d'atomes de carbone de 1 à 3, n indique nombre entier d'au moins 2 et d'au plus 25, et p indique un nombre entier de 1, 2 ou 3.

23. Câble électrique selon la revendication 22, dans lequel le câble électrique est formé comme un conducteur agrégé incluant une pluralité d'âmes qui sont électriquement isolées les unes des autres.

24. Câble électrique selon la revendication 22, dans lequel l'âme est en verre ou en métal.
